# EUROPEAN PATENT APPLICATION

(11) **EP 4 429 411 A1**
(43) Date of publication of application: **11.09.2024**
(21) Application number: 24161547.5
(22) Date of filing: 05.03.2024
(51) Int. Cl.: H05K 1/00, H05K 1/16, C08L 63/00, C08J 5/18, C08K 3/08

(54) **RESIN COMPOSITION**

(30) Priority: 06.03.2023 JP 2023033728
(71) Applicant: AJINOMOTO CO., INC., Chuo-ku Tokyo 104-8315 (JP)
(72) Inventor: SAITO, Mizuki, Kanagawa, 210-0801 (JP); OOYAMA, Hideki, Kanagawa, 210-0801 (JP); TANAKA, Takayuki, Kanagawa, 210-0801 (JP); HOMMA, Tatsuya, Kanagawa, 210-0801 (JP)
(74) Representative: Mewburn Ellis LLP

(57) **Abstract**

A resin composition contains (A) a resin oligomer having a weight-average molecular weight of 600 or more and less than 8000, (B) an epoxy resin excluding those falling under the component (A), and (C) a magnetic powder.

## Description

### BACKGROUND OF THE INVENTION

### 1. Field of the Invention

The present invention relates to a resin composition, as well as a resin sheet, a circuit board, and an inductor component, these being formed by using the resin composition.

### 2. Description of the Related Art

A built-in inductor board having an inductor built in a circuit board such as a printed wiring board is generally formed using a magnetic layer, which is a cured product of a resin composition containing magnetic powder in order to increase an inductance.

For example, in Japanese Patent Application Laid-open No. 2022-120452, it is described that a built-in inductor is formed by using a resin sheet that includes a support and a resin composition layer formed of a resin composition.

When producing the resin sheet, from the viewpoint of making the sheet, the resin composition has been generally required to include a polymer compound having a weight-average molecular weight of about 30000.

However, when the polymer compound is included in the resin composition, a specific magnetic permeability of a cured product of the resin composition layer in the resin sheet can be decreased in some cases.

Another method for suppressing the decrease in the specific magnetic permeability of the cured product is not to include the polymer compound in the resin composition; but in this case, when the support is peeled off from the resin composition layer, whole or a part of the resin composition layer is peeled off together with the support, which can result in poor peeling-off. Hereinafter, the property of smoothly peeling-off the support from the resin composition layer is sometimes referred to as "peelability".

The present invention is made in light of these circumstances; thus, an object of the present invention is to provide a resin composition capable of producing a cured product having a high specific magnetic permeability, a low loss factor, and an excellent peelability, and to provide a resin sheet, a circuit board, and an inductor board, all being obtained by using the resin composition.

### SUMMARY OF THE INVENTION

The inventor of the present invention carried out an extensive investigation to achieve the above-mentioned object, and as a result, it was found that by using a resin composition that includes a combination of a resin oligomer having a weight-average molecular weight of 600 or more and less than 8000, an epoxy resin excluding the resin oligomer, and a magnetic powder, a cured product of a resin composition exhibited a high specific magnetic permeability, a low loss factor, and an excellent peelability. The present invention was completed on the basis of this finding.

Namely, the present invention includes following contents.
[1]. A resin composition comprising:
   (A) a resin oligomer having a weight-average molecular weight of 600 or more and less than 8000;
   (B) an epoxy resin excluding those falling under the component (A); and
   (C) a magnetic powder.
[2]. The resin composition according to [1], wherein the component (A) comprises an epoxy group-containing oligomer.
[3]. The resin composition according to [1] or [2], wherein the resin composition further comprises (D) a polymer compound having a weight-average molecular weight of 8000 or more.
[4]. The resin composition according to any one of [1] to [3], wherein a content (% by volume) of the component (C) relative to 100% by volume of non-volatile components in the resin composition is 70% by volume or more.
[5]. The resin composition according to [3] or [4], wherein Dm/(Am + Dm) is 0 or more and 0.7 or less, provided that Am represents a content of the component (A) and Dm represents a content of the component (D), relative to 100% by mass of non-volatile components in the resin composition.
[6]. The resin composition according to any one of [3] to [5], wherein (Am + Dm)/(Am + Bm + Dm) is 0.1 or more and 0.8 or less, provided that Am represents a content of the component (A), Bm represents a content of the component (B), and Dm represents a content of the component (D), relative to 100% by mass of non-volatile components in the resin composition.
[7]. The resin composition according to any one of [1] to [6], further comprising (E) a solvent.
[8]. A resin sheet comprising:
   a support; and
   a resin composition layer that is formed on the support and formed by using the resin composition according to any one of [1] to [7].
[9]. A circuit board comprising:
   a substrate having a through hole; and
   a cured product of the resin composition according to any one of [1] to [7] filled in the through hole.
[10]. A circuit board comprising a magnetic layer that is a cured product of the resin composition according to any one of [1] to [7].
[11]. An inductor board comprising the circuit board according to [9].
[12]. An inductor board comprising the circuit board according to [10].

### Advantageous Effects of Invention

According to the present invention, provided are: a resin sheet capable of producing a cured product having an enhanced specific magnetic permeability, a lowered loss factor, and excellent peelability; and a circuit board and an inductor component, both being obtained by using the resin sheet.

### BRIEF DESCRIPTION OF THE DRAWINGS

Fig. 1 is a schematic sectional view illustrating a core substrate before forming a through hole in a circuit board producing method according to a first embodiment;
Fig. 2 is a schematic sectional view illustrating the core substrate formed with the through hole in the circuit board producing method according to the first embodiment;
Fig. 3 is a schematic sectional view illustrating the core substrate having a plated layer formed in the through hole in the circuit board producing method according to the first embodiment;
Fig. 4 is a schematic sectional view illustrating the state of laminating the core substrate with a resin sheet in the circuit board producing method according to the first embodiment;
Fig. 5 is a schematic sectional view illustrating the laminated state of the core substrate with the resin sheet in the circuit board producing method according to the first embodiment;
Fig. 6 is a schematic sectional view to explain step (2) in the circuit board producing method according to the first embodiment;
Fig. 7 is a schematic sectional view to explain step (3) in the circuit board producing method according to the first embodiment;
Fig. 8 is a schematic sectional view to explain step (5) in the production method of the circuit board according to the first embodiment;
Fig. 9 is a schematic sectional view to explain the step (5) in the production method of the circuit board according to the first embodiment;
Fig. 10 is a schematic sectional view to explain step (A) in a circuit board producing method according to a second embodiment;
Fig. 11 is a schematic sectional view to explain the step (A) in the circuit board producing method according to the second embodiment;
Fig. 12 is a schematic sectional view to explain step (B) in the circuit board producing method according to the second embodiment;
Fig. 13 is a schematic sectional view to explain step (D) in the circuit board producing method according to the second embodiment;
Fig. 14 is a schematic plan view observed from one side along the thickness direction of an inductor component that includes the circuit board obtained by the circuit board producing method according to the second embodiment;
Fig. 15 is a schematic view illustrating a cut end face of the inductor component including the circuit board obtained by the circuit board producing method according to the second embodiment; the inductor component being cut at the place indicated by the II-II one dot chain line; and
Fig. 16 is a schematic plan view to explain a composition of a first conductive layer in the inductor component that includes the circuit board obtained by the circuit board producing method according to the second embodiment.

### DETAILED DESCRIPTION OF THE PREFERRED EMBODIMENTS

Hereinafter, with referring to the drawings, embodiments of the present invention will be explained. In these drawings, the shape, size, and arrangement of the composition elements are roughly illustrated so as to merely help to understand the present invention. The present invention is not limited by the embodiments described below; and thus, each of the composition elements may be changed as appropriate. In the following drawings to be used for explanation, the same composition elements are assigned the same symbols and an overlapped explanation thereof may be omitted. In addition, the compositions relating to the embodiments of the present invention are not necessarily produced or used in accordance with the arrangements illustrated in the drawings.

### Resin Composition

The resin composition according to the present invention includes (A) a resin oligomer having a weight-average molecular weight of 600 or more and less than 8000, (B) an epoxy resin (excluding those falling under the component (A)), and (C) a magnetic powder. By using the resin composition as described above, it is possible to obtain a cured product having a high specific magnetic permeability, a low loss factor, and an excellent peelability. It is also usually possible to obtain a resin composition having a low melt viscosity.

The resin composition may further include optional components such as (D) a polymer compound having a weight-average molecular weight of 8000 or more, (E) a solvent, (F) a curing agent, (G) a dispersing agent, and (H) other additives, as needed.

Hereinafter, each component included in the resin composition will be described in detail. In the present invention, the content of each component in the resin composition is a value relative to 100% by mass of non-volatile components in the resin composition unless otherwise specifically mentioned, in which the non-volatile components mean non-volatile components excluding the solvent in the resin composition.

### (A) Resin Oligomer Having Weight-average Molecular Weight of 600 or More and Less Than 8000

The resin composition contains (A) a resin oligomer having a weight-average molecular weight of 600 or more and less than 8000 as the component (A). By including the resin oligomer having a weight-average molecular weight of 600 or more and less than 8000 (A) in the resin composition, it is possible to obtain a cured product of the resin composition having a high specific magnetic permeability, a low loss factor, and an excellent peelability. The component (A) may be used singly, or as a combination of two or more kinds of oligomers.

Because the component (A) has a shorter molecular length than the polymer compounds that have been conventionally used, the distance between the magnetic powders (C) included in the resin composition becomes shorter. As a result, it is presumed that the specific magnetic permeability of the cured product is increased due to the increase in the magnetic moment.

The weight-average molecular weight of the component (A) is 600 or more, preferably 700 or more, and more preferably 800 or more. The upper limit thereof is preferably less than 8000, preferably 7500 or less, and more preferably 7000 or less. Note that the weight-average molecular weight of the resin is the weight-average molecular weight in terms of polystyrene measured with a gel permeation chromatography (GPC) method.

As for the resin oligomer (A) having a weight-average molecular weight of 600 or more and less than 8000, any of a thermosetting resin oligomer having a thermosetting functional group such as an epoxy group and a thermoplastic resin oligomer is preferable, and the thermosetting resin oligomer is more preferable. Illustrative examples of the thermosetting resin oligomer include an epoxy group-containing oligomer and a phenol resin oligomer. The term "epoxy group-containing oligomer" means an oligomer having an epoxy group. In particular, the epoxy group-containing oligomer is preferable as the component (A).

It is preferable that the epoxy group-containing oligomer contains two or more epoxy groups in one molecule. In addition, the epoxy group-containing oligomer having an aromatic structure is preferable. When two or more epoxy group-containing oligomers are used, it is more preferable that at least one of them has an aromatic structure. The aromatic structure is the chemical structure that is generally defined as an aromatic compound, including a polycyclic aromatic compound and an aromatic heterocycle. The ratio of the epoxy group-containing oligomer having two or more epoxy groups in one molecule relative to 100% by mass of the non-volatile components in the epoxy group-containing oligomer is preferably 50% by mass or more, more preferably 60% by mass or more, and especially preferably 70% by mass or more.

As for the epoxy group-containing oligomer, a bisphenol type epoxy group-containing oligomer is preferable, and a bisphenol A type epoxy group-containing oligomer, a bisphenol F type epoxy group-containing oligomer, and a bisphenol AF type epoxy group-containing oligomer are preferable, and any of the bisphenol A type epoxy group-containing oligomer and the bisphenol F type epoxy group-containing oligomer is more preferable. Illustrative examples of the epoxy group-containing oligomer include specifically "jER1001" (bisphenol A type epoxy group-containing oligomer), "jER4005P" (bisphenol F type epoxy group-containing oligomer), "jER1004AF (polyether type epoxy group-containing oligomer produced from bisphenol A), "jER4005P" (bisphenol F type epoxy group-containing oligomer), and "jER1010" (bisphenol A type epoxy resin), all of which are manufactured by Mitsubishi Chemical Corp.; and "EXA-4850-150" (modified bisphenol type epoxy resin) manufactured by DIC Corp. These may be used singly or as a combination of two or more of them.

The epoxy equivalent of the epoxy group-containing oligomer is preferably in the range of 50 g/eq. to 5000 g/eq., more preferably in the range of 50 g/eq. to 3000 g/eq., still more preferably in the range of 80 g/eq. to 2000 g/eq., and far still more preferably in the range of 110 g/eq. to 1000 g/eq. Within these ranges, the crosslinking density of the cured product is sufficient, so that a magnetic layer having a low surface roughness may be obtained. The epoxy equivalent, which is a mass of the resin including one equivalent of the epoxy group, may be measured with a method in accordance with JIS K7236.

As for the phenol resin oligomer, a commercially available product may be used. Illustrative examples of the commercially available phenol resin oligomer include "S-1P" and "S-1P" manufactured by Maruzen Petrochemical Co., Ltd.

The content of the component (A) relative to 100% by mass of the non-volatile components in the resin composition is, from the viewpoint to clearly obtain the advantageous effects of the present invention, preferably 0.1% by mass or more, more preferably 0.2% by mass or more, still more preferably 0.25% by mass or more, and preferably 5% by mass or less, more preferably 3% by mass or less, and still more preferably 1% by mass or less.

### (B) Epoxy Resin

The resin composition includes (B) an epoxy resin as the component (B). The epoxy resin (B) as the component (B) does not include those that fall under the component (A) described above. By including the epoxy resin (B) in the resin composition, it is possible to obtain a cured product of the resin composition having an excellent peelability. The epoxy resin (B) may be used singly or as a combination of two or more kinds.

Illustrative examples of the epoxy resin (B) include: a bisphenol A type epoxy resin; a bisphenol F type epoxy resin; a bisphenol S type epoxy resin; a bisphenol AF type epoxy resin; a dicyclopentadiene type epoxy resin; a trisphenol type epoxy resin; a phenol novolac type epoxy resin; a tert-butyl-catechol type epoxy resin; an epoxy resin having a condensed cyclic structure such as a naphthol novolac type epoxy resin, a naphthalene type epoxy resin, a naphthol type epoxy resin, and an anthracene type epoxy resin; a glycidyl amine type epoxy resin; a glycidyl ester type epoxy resin; a cresol novolac type epoxy resin; a biphenyl type epoxy resin; a linear aliphatic epoxy resin; an epoxy resin having a butadiene structure; an alicyclic epoxy resin; a heterocyclic epoxy resin; an epoxy resin having a spiro ring; a cyclohexane dimethanol type epoxy resin; a trimethylol type epoxy resin; a tetraphenylethane type epoxy resin; and a cyclic aliphatic diglycidyl ether type epoxy resin. These epoxy resins may be used singly or as a combination of two or more of those described above. The epoxy resin (B) is preferably one or more kinds selected from a bisphenol A type epoxy resin and a bisphenol F type epoxy resin, and more preferably to include a bisphenol A type epoxy resin and a bisphenol F type epoxy resin.

It is preferable that the epoxy resin (B) includes an epoxy resin having two or more epoxy groups in one molecule. In addition, it is preferable that the epoxy resin (B) has an aromatic structure. When two or more of the epoxy resins are used, it is more preferable that at least one of them has an aromatic structure. The aromatic structure is the chemical structure that is generally defined as an aromatic compound, including a polycyclic aromatic compound and an aromatic heterocycle. The ratio of the epoxy resin having two or more epoxy groups in one molecule relative to 100% by mass of the non-volatile components in the epoxy resin is preferably 50% by mass or more, and more preferably 60% by mass or more, and especially preferably 70% by mass or more.

In the epoxy resin, there are an epoxy resin that is in the state of liquid at 25°C (hereinafter, this is sometimes called "liquid epoxy resin") and an epoxy resin that is in the state of solid at 25°C (hereinafter, this is sometimes called "solid epoxy resin"). The resin composition may include, as the epoxy resin (B), only the liquid epoxy resin, or only the solid epoxy resin, or the liquid epoxy resin and the solid epoxy resin as a combination; but, from the viewpoint to decrease a viscosity of the resin composition, it is preferable to include only the liquid epoxy resin.

The liquid epoxy resin is preferably a glycirol type epoxy resin, a bisphenol A type epoxy resin, a bisphenol F type epoxy resin, a bisphenol AF type epoxy resin, a naphthalene type epoxy resin, a glycidyl ester type epoxy resin, a glycidyl amine type epoxy resin, a phenol novolac type epoxy resin, an alicyclic epoxy resin having an ester skeleton, a cyclohexane dimethanol type epoxy resin, an alicyclic diglycidyl ether type epoxy resin, an alicyclic glycidyl ether type epoxy resin, an alicyclic glycidyl ether type epoxy resin, and an epoxy resin having a butadiene structure. Among these, a bisphenol A type epoxy resin and a bisphenol F type epoxy resin are more preferable. Specific examples of the liquid epoxy resin include "HP4032", "HP4032D", and "HP4032SS" (naphthalene type epoxy resins), which are all manufactured by DIC Corp.; "828US" and "jER828EL" (bisphenol A type epoxy resins), "jER807" (bisphenol F type epoxy resin), and "jER152" (phenol novolac type epoxy resin), which are all manufactured by Mitsubishi Chemical Corp.; "630" and "630LSD", which are both manufactured by Mitsubishi Chemical Corp.; "ED-523T" (glycirol type epoxy resin (ADEKA glycirol)), "EP-3980S" (glycidyl amine type epoxy resin), and "EP-4088S" (dicyclopentadiene type epoxy resin), which are all manufactured by ADEKA Corp.; "ZX1059" (mixture of bisphenol A type epoxy resin and bisphenol F type epoxy resin), "EX-201" (alicyclic glycidyl ether type epoxy resin), "ZX1658" and "ZX1658GS (alicyclic diglycidyl ether type epoxy resins), which are all manufactured by Nippon Steel Chemical & Material Co., Ltd.; "EX-721" (glycidyl ester type epoxy resin) manufactured by Nagase ChemteX Corp.; and "Celloxide 2021P" (alicyclic epoxy resin having an ester skeleton) and "PB-3600" (epoxy resin having a butadiene structure), which are both manufactured by Daicel Corp. These may be used singly or as a combination of two or more of them.

The solid epoxy resin is preferably a naphthalene type 4-functional epoxy resin, a cresol novolac type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, and a tetraphenylethane type epoxy resin. Specific examples of the solid epoxy resin include: "HP4032H" (naphthalene type epoxy resin), "HP-4700" and "HP-4710" (both are naphthalene type 4-functional epoxy resins); "N-690" (cresol novolac type epoxy resin), "N-695" (cresol novolac type epoxy resin), "HP-7200", "HP-7200HH", and "HP-7200H" (all are dicyclopentadiene type epoxy resins), "EXA-7311", "EXA-7311-G3", "EXA-7311-G4", "EXA-7311-G4S", and "HP6000" (all are naphthylene ether type epoxy resins), all of these resins being manufactured by DIC Corp.; "EPPN-502H" (trisphenol type epoxy resin), "NC7000L" (naphthol novolac type epoxy resin), and "NC3000H", "NC3000", "NC3000L", and "NC3100" (all are biphenyl type epoxy resins), all of these resins being manufactured by Nippon Kayaku Co., Ltd.; "ESN475V" (naphthalene type epoxy resin) and "ESN485" (naphthol novolac type epoxy resin), both being manufactured by Nippon Steel Chemical & Material Co., Ltd.; "YX4000H" and "YL6121" (both are biphenyl type epoxy resins), "YX4000HK" (bixylenol type epoxy resin), and "YX8800" (anthracene type epoxy resin), all of them being manufactured by Mitsubishi Chemical Corp.; "PG-100" and "CG-500", both being manufactured by Osaka Gas Chemicals Co., Ltd.; and "YL7760" (bisphenol AF type epoxy resin), "YL7800" (fluorene type epoxy resin), "jER1010" (solid bisphenol A type epoxy resin), and "jER1031S" (tetraphenylethane type epoxy resin), all of them being manufactured by Mitsubishi Chemical Corp. These may be used singly or as a combination of two or more of them.

When the liquid epoxy resin and the solid epoxy resin are used in combination as the epoxy resin (B), the quantity ratio (in mass ratio) thereof (liquid epoxy resin:solid epoxy resin) is preferably in the range of 1:0.1 to 1:4. By setting the quantity ratio of the liquid epoxy resin to the solid epoxy resin in the range described above, it is possible to obtain a cured product expressing advantageous effects including a sufficient rupture strength. From the viewpoint of the advantageous effects, the quantity ratio (in mass ratio) of the liquid epoxy resin to the solid epoxy resin (liquid epoxy resin:solid epoxy resin) is more preferably in the range of 1:0.3 to 1:3.5, still more preferably in the range of 1:0.6 to 1:3, and especially preferably in the range of 1:0.8 to 1:2.5.

The epoxy equivalent of the epoxy resin (B) is preferably in the range of 50 g/eq. to 5000 g/eq., more preferably in the range of 50 g/eq. to 3000 g/eq., still more preferably in the range of 80 g/eq. to 2000 g/eq., and far still more preferably in the range of 110 g/eq. to 1000 g/eq. Within this range, the crosslinking density of the cured product is sufficient, so that a magnetic layer having a low surface roughness may be obtained. The epoxy equivalent, which is a mass of the resin including one equivalent of the epoxy group, may be measured with a method in accordance with JIS K7236.

The weight-average molecular weight (Mw) of the epoxy resin (B) is preferably less than 600, more preferably 500 or less, and still more preferably 400 or less. The lower limit thereof is not particularly restricted; this is preferably 100 or more, more preferably 150 or more, and still more preferably 200 or more.

From the viewpoint of obtaining the magnetic layer having an excellent mechanical strength, the content of the epoxy resin (B) (% by mass) relative to 100% by mass of the non-volatile components in the resin composition is preferably 0.1% by mass or more, more preferably 0.3% by mass or more, still more preferably 0.5% by mass or more, and especially preferably 1% by mass or more. Although the upper limit of the content of the epoxy resin is not particularly restricted as long as the advantageous effects of the present invention are expressed, this is preferably 5% by mass or less, more preferably 3% by mass or less, and still more preferably 2% by mass or less.

The content of the epoxy resin (B) (% by volume) relative to 100% by volume of the non-volatile components in the resin composition is preferably 1% by volume or more, more preferably 3% by volume or more, and still more preferably 5% by volume or more. Although the upper limit thereof is not particularly restricted as long as the advantageous effects of the present invention are expressed, this is preferably 25% by volume or less, more preferably 20% by volume or less, and still more preferably 15% by mass or less.

### (C) Magnetic Powder

The resin composition includes (C) a magnetic powder as the component (C). By including the magnetic powder (C) in the resin composition, the specific magnetic permeability of the cured product of the resin composition may be increased and the loss factor may be decreased. The magnetic powder (C) may be used singly, or two or more kinds of the powders may be used in combination.

Particles of the material having a specific magnetic permeability of more than 1 may be used as the magnetic powder (C). As one embodiment of the magnetic powder (C), it is preferable to include any of a nanocrystalline magnetic powder and a small-diameter magnetic powder; and it is more preferable to include a nanocrystalline magnetic powder.

The term "nanocrystalline magnetic powder" refers to the magnetic powder including crystal particles having a particle diameter of 100 nm or less. There is no particular restriction in the lower limit of the particle diameter of the crystalline particle, but it is preferably 1 nm or more. In particular, the nanocrystalline magnetic powder having a maximum particle diameter of 100 nm or less is preferable. Usually, a single nanocrystalline magnetic powder particle includes a plurality of crystalline particles, and thus the particle of the nanocrystalline magnetic powder may be polycrystalline. The size of the crystalline particle may be observed, for example, by a transmission electron microscopy (TEM). Because the nanocrystalline magnetic powder includes the crystalline particles, in general, this may exhibit peaks that indicate crystallinity in the X-ray diffraction pattern. For example, the bcc crystal structure (body-centered cubic lattice structure) may be cited as the crystal structure possessed by the crystalline particle, but other crystal structures may also be allowed.

Usually, the nanocrystalline magnetic powder is included in the resin composition in the form of particle. The nanocrystalline magnetic powder may include a crystalline particle at least in part of the particle thereof, in which the one including the crystalline particle on the surface layer of the particle is preferable, the one including the crystal particle throughout the particle is more preferable, and the one consisting of only the crystalline particle is especially preferable.

Usually, the nanocrystalline magnetic powder has a particle diameter in the range of 5.5 um or more to 20 um or less. The particle diameter of the nanocrystalline magnetic powder may be measured with a laser diffraction and scattering method based on the Mie scattering theory. Specifically, the particle size distribution of the nanocrystalline magnetic powder is prepared on the basis of a volume standard by using a laser diffraction scattering type particle size distribution measurement instrument, and the diameter thereof may be measured from this particle size distribution. The nanocrystalline magnetic powders that are dispersed in pure water by means of an ultrasonic wave may be preferably used as the measurement sample. Illustrative examples of the laser diffraction scattering type particle size distribution measurement instrument include "MT3000II" manufactured by MicrotracBEL Corp., "LA-960" manufactured by Horiba, Ltd., and "SALD-2200" manufactured by Shimadzu Corp.

The average particle diameter D₅₀ of the nanocrystalline magnetic powder is usually 5.5 um or more, preferably 5.7 um or more, more preferably 5.9 um or more, and usually 20 um or less, preferably 18 um or less, and more preferably 16 um or less. By using the nanocrystalline magnetic powder having the average particle diameter D₅₀ in the range described above, it is possible to improve the specific magnetic permeability, the loss factor, and the peelability. The average particle diameter D₅₀ of the nanocrystalline magnetic powder represents the median diameter on a volume basis and may be measured from the particle size distribution on a volume basis measured by the laser diffraction and scattering method described before.

The volume-based particle size distribution of the nanocrystalline magnetic powder usually follows a normal distribution. Thus, it is possible that the nanocrystalline magnetic powder has a 10%-particle diameter D₁₀, which is smaller than the average particle diameter D₅₀ of the nanocrystalline magnetic powder, and a 90%-particle diameter D₉₀, which is larger than the average particle diameter D₅₀ of the nanocrystalline magnetic powder. Here, the 10%-particle diameter D₁₀ represents the particle diameter when the cumulative volume amount from the small particle diameter side becomes 10% in the particle size distribution on a volume basis. The 90%-particle diameter D₉₀ represents the particle diameter when the cumulative volume amount from the small particle diameter side becomes 90% in the particle size distribution on a volume basis. The 10%-particle diameter D₁₀ and the 90%-particle diameter D₉₀ of the nanocrystalline magnetic powder may be measured from the volume-based particle size distribution measured by the laser diffraction and scattering method described before.

The 10%-particle diameter D₁₀ of the nanocrystalline magnetic powder is preferably more than 2.0 um, more preferably 2.4 um or more, and especially preferably 2.8 um or more. The upper limit thereof is equal to or less than the average particle diameter D₅₀; thus, this may be, for example, 10 um or less, 8 µm or less, and 6 um or less. When the 10%-particle diameter D₁₀ of the nanocrystalline magnetic powder is in the range described above, it is possible to improve the specific magnetic permeability, the loss factor, and the peelability.

The upper limit of the 90%-particle diameter D₉₀ of the nanocrystalline magnetic powder is preferably 60 um or less, more preferably 50 um or less, and especially preferably 40 um or less. The lower limit thereof is more than or equal to the average particle diameter D₅₀; thus, this may be, for example, 6 um or more, 8 um or more, and 10 µm or more. When the 90%-particle diameter D₉₀ of the nanocrystalline magnetic powder is in the range described above, it is possible to improve the specific magnetic permeability, the loss coefficient, and the peelability.

The difference between the 10%-particle diameter D₁₀ and the 90%-particle diameter D₉₀ of the nanocrystalline magnetic powder, i.e., D₉₀ - D₁₀, is preferably 1 um or more, more preferably 3 um or more, and especially preferably 5 um or more, and preferably 40 um or less, more preferably 35 um or less, and especially preferably 30 um or less. When the difference D₉₀ - D₁₀ is in the range described above, it is possible to improve the specific magnetic permeability, the loss factor, and the peelability.

The ratio of the 10%-particle diameter D₁₀ and the 90%-particle diameter D₉₀ of the nanocrystalline magnetic powder, i.e., D₉₀/D₁₀, is preferably 1.1 or more, more preferably 2 or more, and especially preferably 3 or more, and preferably 10 or less, more preferably 8 or less, and especially preferably 6 or less. When the ratio D₉₀/D₁₀ is in the range described above, it is possible to improve the specific magnetic permeability, the loss factor, and the peelability.

The nanocrystalline magnetic powder may be the magnetic material particle having the specific magnetic permeability of more than 1. Usually, this magnetic material is an inorganic material, in which it may be a soft magnetic material or a hard magnetic material. In addition, the magnetic material may be used singly or as a combination of two or more of those described above. In particular, from the viewpoint of suppressing uneven distribution of the nanocrystalline magnetic powders, a soft magnetic material is preferable as the magnetic material included in the nanocrystalline magnetic powder.

Illustrative examples of the magnetic material included in the nanocrystalline magnetic powder include a magnetic metal oxide and a magnetic metal. In particular, it is preferable that the magnetic material contained in the nanocrystalline magnetic powder includes iron (Fe). Therefore, illustrative examples of the magnetic material that is contained in the nanocrystalline magnetic powder include an iron alloy magnetic material having crystallinity and a ferrite magnetic material having crystallinity. From the viewpoint of the specific magnetic permeability and the loss factor, it is preferable that the magnetic material contained in the nanocrystalline magnetic powder has a composition that further contains one or more elements selected from the group consisting of Nb, Hf, Zr, Ta, Mo, W, and V in combination with Fe.

Illustrative examples of the preferable magnetic material contained in the nanocrystalline magnetic powder include the magnetic materials described in Japanese Patent Application Laid-open Nos. 2021-158343, 2021-141267, 2019-31463, and 2021-11602.

Among the above examples, from the viewpoint of the specific magnetic permeability and the loss factor, a Fe-Si-Nb-B alloy powder is preferable. The Fe-Si-Nb-B alloy powder represents the magnetic powder formed from an alloy containing Fe, Si, Nb, and B.

It is preferable that the nanocrystalline magnetic powder includes the magnetic materials mentioned above, and includes only the magnetic materials mentioned above. In addition, the nanocrystalline magnetic powder may be used singly or as a combination of two or more of those described above.

The nanocrystalline magnetic powder may be produced, for example, by an atomization method. Specific examples of the method for producing the nanocrystalline magnetic powder include those described in Japanese Patent Application Laid-open Nos. 2021-141267 and 2021-158343.

The nanocrystalline magnetic powders that are commercially available may be used. Illustrative examples of the commercially available magnetic powder containing the nanocrystalline magnetic powder include "KUAMET NC1-53 um", "KUAMET NC1-38 µm", and "ATFINE-NC1 PF10FA", all being manufactured by Epson Atmix Corp. If the nanocrystalline magnetic powder is obtained from the market, commercially available magnetic powder may be used after having been classified, as needed.

The nanocrystalline magnetic powder is preferably spherical. The value obtained by dividing the length of the longitude axis by the length of the short axis (aspect ratio) of the particle of the nanocrystalline magnetic powder is preferably 2 or less, more preferably 1.5 or less, still more preferably 1.2 or less, and usually 1 or more, preferably more than 1, and more preferably 1.05 or more.

The content (% by mass) of the nanocrystalline magnetic powder relative to 100% by mass of the non-volatile components in the resin composition is preferably 30% by mass or more, more preferably 40% by mass or more, still more preferably 50% by mass or more, and preferably 90% by mass or less, more preferably 85% by mass or less, and still more preferably 80% by mass or less. When the content of the nanocrystalline magnetic powder is in the range described above, it is possible to improve the specific magnetic permeability, the loss factor, and the peelability.

The content (% by volume) of the nanocrystalline magnetic powder relative to 100% by volume of the non-volatile components in the resin composition is preferably 23% by volume or more, more preferably 25% by volume or more, still more preferably 28% by volume or more, and preferably 60% by volume or less, more preferably 50% by volume or less, and still more preferably 40% by volume or less. When the content of the nanocrystalline magnetic powder is in the range described above, it is possible to improve the specific magnetic permeability, the loss factor, and the peelability.

Usually, a small-diameter magnetic powder is included in the resin composition in the form of a particle. This small-diameter magnetic powder usually has a particle diameter of 2 um or less. The particle diameter of the small-diameter magnetic powder may be measured by the same method as that for the nanocrystalline magnetic powder.

The average particle diameter D₅₀ of the small-diameter magnetic powder is usually 2 um or less, preferably 1.5 um or less, and more preferably 1 um or less. The lower limit thereof may be 0.01 um or more, 0.1 um or more, or the like. By using the small-diameter magnetic powder having the average particle diameter D₅₀ in the range described above, it is possible to improve the specific magnetic permeability, the loss factor, and the peelability. The average particle diameter D₅₀ of the small-diameter magnetic raw material powder represents the median diameter on a volume basis and may be measured by the same method as that for the average particle diameter D₅₀ of the nanocrystalline magnetic powder.

The volume-based particle size distribution of the small-diameter magnetic powder usually follows a normal distribution. Thus, the small-diameter magnetic powder may have a 10%-particle diameter D₁₀, which is smaller than the average particle diameter D₅₀ of the small-diameter magnetic powder, and a 90%-particle diameter D₉₀, which is larger than the average particle diameter D₅₀ of the small-diameter magnetic powder. The 10%-particle diameter D₁₀ and the 90%-particle diameter D₉₀ of the small-diameter magnetic powder may be measured in the same way as the 10%-particle diameter D₁₀ and the 90%-particle diameter D₉₀ of the nanocrystalline magnetic powder.

The 10%-particle diameter D₁₀ of the small-diameter magnetic powder is preferably 0.01 um or more, more preferably 0.02 um or more, and especially preferably 0.03 um or more. The upper limit thereof is equal to or less than the average particle diameter D₅₀; thus, this may be, for example, 1 um or less, 0.7 um or less, and 0.5 um or less. When the 10%-particle diameter D₁₀ of the small-diameter magnetic powder is in the range described above, it is possible to improve the specific magnetic permeability, the loss factor, and the peelability.

The 90%-particle diameter D₉₀ of the small-diameter magnetic powder is preferably less than 5.5 um, more preferably 4 um or less, and especially preferably 2 um or less. The lower limit thereof is equal to or more than the average particle diameter D₅₀; thus, this may be, for example, 0.5 um or more, 0.8 um or more, and 1 µm or more. When the 90%-particle diameter D₉₀ of the small-diameter magnetic powder is in the range described above, it is possible to improve the specific magnetic permeability, the loss factor, and the peelability.

The difference between the 10%-particle diameter D₁₀ and the 90%-particle diameter D₉₀ of the small-diameter magnetic powder, i.e., D₉₀ - D₁₀, is preferably 0.1 um or more, more preferably 0.3 um or more, and especially preferably 0.5 um or more, and preferably 5 µm or less, more preferably 4 µm or less, and especially preferably 3 µm or less. When the difference D₉₀ - D₁₀ is in the range described above, it is possible to improve the specific magnetic permeability, the loss factor, and the peelability.

The ratio of the 10%-particle diameter D₁₀ and the 90%-particle diameter D₉₀ of the small-diameter magnetic powder, i.e., D₉₀/D₁₀, is preferably 1.1 or more, more preferably 1.5 or more, and especially preferably 2 or more, and preferably 50 or less, more preferably 40 or less, and especially preferably 30 or less. When the ratio D₉₀/D₁₀ is in the range described above, it is possible to improve the specific magnetic permeability, the loss factor, and the peelability.

The small-diameter magnetic powder may be the nanocrystalline magnetic powder containing a crystalline particle, an amorphous magnetic powder not containing a crystalline particle, a crystalline magnetic powder other than the nanocrystalline magnetic powder, or a combination of these. The nanocrystalline magnetic powder is as described above. An amorphous magnetic material is amorphous, so that usually, this does not exhibit specific peaks in the X-ray diffraction pattern that indicate crystallinity. In general, a broad pattern without peaks indicating crystallinity appears in the X-ray diffraction pattern of the amorphous magnetic powder.

The small-diameter magnetic powder may be a magnetic material particle having a specific magnetic permeability of more than 1. Usually, this magnetic material is an inorganic material, in which it may be a soft magnetic material or a hard magnetic material. In addition, the magnetic material may be used singly or as a combination of two or more of those described above. In particular, from the viewpoint of suppressing uneven distribution of the small-diameter magnetic powder, a soft magnetic material is preferable as the magnetic material contained in the small-diameter magnetic powder.

Illustrative examples of the magnetic material contained in the small-diameter magnetic powder include a magnetic metal oxide material and a magnetic metal material.

Illustrative examples of the magnetic metal oxide material include a ferrite type magnetic material; and an iron oxide material such as iron oxide powder (III) and triiron tetraoxide powder. Among these, a ferrite type magnetic material is preferable. The ferrite type magnetic material is usually a composite oxide mainly formed of iron oxides and is chemically stable. Therefore, using the ferrite type magnetic material offers advantages such as a high corrosion resistance, a low risk of ignition, and a resistance to demagnetization.

Illustrative examples of the ferrite type magnetic material include a Fe-Mn type ferrite, a Fe-Mn-Mg type ferrite, a Fe-Mn-Mg-Sr type ferrite, a Fe-Mg-Zn type ferrite, a Fe-Mg-Sr type ferrite, a Fe-Zn-Mn type ferrite, a Fe-Cu-Zn type ferrite, a Fe-Ni-Zn type ferrite, a Fe-Ni-Zn-Cu type ferrite, a Fe-Ba-Zn type ferrite, a Fe-Ba-Mg type ferrite, a Fe-Ba-Ni type ferrite, a Fe-Ba-Co type ferrite, a Fe-Ba-Ni-Co type ferrite, and a Fe-Y type ferrite.

Among the ferrite type magnetic materials, a ferrite that contains at least one element selected from the group consisting of Mn, Zn, Ni, and Cu is preferable; and a ferrite that contains Mn is especially preferable. Therefore, illustrative examples of the preferable ferrite type magnetic material include a Fe-Mn type ferrite, a Fe-Mn-Mg type ferrite, a Fe-Mn-Mg-Sr type ferrite, a Fe-Mg-Zn type ferrite, a Fe-Zn-Mn type ferrite, a Fe-Cu-Zn type ferrite, a Fe-Ni-Zn type ferrite, a Fe-Ni-Zn-Cu type ferrite, a Fe-Ba-Zn type ferrite, a Fe-Ba-Ni type ferrite, and a Fe-Ba-Ni-Co type ferrite. Among them, a Fe-Mn type ferrite, a Fe-Mn-Mg type ferrite, a Fe-Mn-Mg-Sr type ferrite, and a Fe-Zn-Mn type ferrite are preferable, and a Fe-Mn type ferrite is especially preferable. The Fe-Mn ferrite represents the ferrite that contains Fe and Mn.

Illustrative examples of the magnetic metal material include a pure iron; and crystalline or amorphous alloy magnetic materials such as a Fe-Si type alloy, a Fe-Si-Al type alloy, a Fe-Cr type alloy, a Fe-Cr-Si type alloy, a Fe-Ni-Cr type alloy, a Fe-Cr-Al type alloy, a Fe-Ni type alloy, a Fe-Ni-B type alloy, a Fe-Ni-Mo type alloy, a Fe-Ni-Mo-Cu type alloy, a Fe-Co type alloy, a Fe-Ni-Co type alloy, and a Co-based amorphous alloy. Among the magnetic metal materials, an iron alloy type magnetic material is more preferable. From the viewpoints of the specific magnetic permeability and the loss factor, an iron alloy type magnetic material containing Fe, as well as at least one element selected from the group consisting of Si, Cr, Al, Ni, and Co is preferable, and a Fe-Si-Cr type alloy is especially preferable. The Fe-Si-Cr type alloy material represents an alloy containing Fe, Si, and Cr.

As the magnetic material included in the small-diameter magnetic powder, the magnetic material described as the magnetic material of the nanocrystalline magnetic powder may also be used. The magnetic material included in the small-diameter magnetic powder and the magnetic material of the nanocrystalline magnetic powder may be the same or different.

It is preferable that the small-diameter magnetic powder includes the magnetic material described above, or includes only the magnetic material described above. In addition, the small-diameter magnetic powder may be used one kind singly or as a combination of two or more kinds thereof.

Small-diameter magnetic powders that are commercially available may be used. Specific examples of the commercially available magnetic powder include: "MZ03S", "M05S", "M001", and "MZ05S", all of which are manufactured by Powdertech Co., Ltd.; "PST-S" manufactured by Sanyo Special Steel Co., Ltd.; "AW2-08", "AW2-08PF20F", "AW2-08PF10F", "AW2-08PF3F", "Fe-3.5Si-4.5CrPF20F", "Fe-50NiPF20F", "Fe-80Ni-4MoPF20F", "ATFINE-NC1·PF5FA", and "ATFINE-NC1·PF3FA", all of which are manufactured by Epson Atmix Corp.; "CVD iron powder (0.7 um)","LD-M", "LD-MH", "KNI-106", "KNI-106GSM", "KNI-106GS", "KNI-109", "KNI-109GSM", and "KNI-109GS", all of which are manufactured by JFE Chemical Corp.; "KNS-415", "BSF-547", "BSF-029", "BSN-125", "BSN-125", "BSN-714", "BSN-828", "S-1281", "S-1641", "S-1651", "S-1470", "S-1511", and "S-2430", all of which are manufactured by Toda Kogyo Corp.; "JR09P2" manufactured by Japan Metals and Chemicals Co., Ltd.; "Nanotek" manufactured by CIK-NanoTek Corp.; "JEMK-S" and "JEMK-H", which are manufactured by Kinsei Matec Co., Ltd.; "Yttrium iron oxide" manufactured by Aldrich; and "MA-RCO-5" manufactured by DOWA Electronics Materials Co., Ltd. When the small-diameter magnetic powder is obtained from the market, commercially available magnetic powders may be used after having been classified, as needed.

The small-diameter magnetic powder is preferably spherical. The range of the aspect ratio of the particle of the small-diameter magnetic powder may be the same as the range of the aspect ratio of the nanocrystalline magnetic powder. The aspect ratio of the small-diameter magnetic powder and the aspect ratio of the nanocrystalline magnetic powder may be the same or different.

The content (% by mass) of the small-diameter magnetic powder relative to 100% by mass of the non-volatile components in the resin composition is preferably 1% by mass or more, more preferably 5% by mass or more, and especially preferably 8% by mass or more, and preferably 50% by mass or less, more preferably 40% by mass or less, and still more preferably 35% by mass or less. When the content of the small-diameter magnetic powder is in the range described above, it is possible to improve the specific magnetic permeability, the loss factor, and the peelability.

The content (% by volume) of the small-diameter magnetic powder relative to 100% by volume of the non-volatile components in the resin composition is preferably 5% by volume or more, more preferably 6% by volume or more, and especially preferably 7% by volume or more, and preferably 30% by volume or less, more preferably 26% by volume or less, and still more preferably 22% by volume or less. When the small-diameter magnetic powder with the content described above is used, it is possible to improve the specific magnetic permeability, the loss factor, and the peelability.

Relative to 100% by volume of the non-volatile components in the resin composition, the content (% by volume) of the nanocrystalline magnetic powder is represented by "V(A)" and the content (% by volume) of the small-diameter magnetic powder is represented by "V(B)". In this case, the volume ratio of the nanocrystalline magnetic powder to the small-diameter magnetic powder included in the resin composition (nanocrystalline magnetic powder/small-diameter magnetic powder) may be expressed as "V (A) /V (B) ". This volume ratio V(A)/V(B) is usually 0.8 or more, preferably 1 or more, more preferably 1.2 or more, and especially preferably 1.4 or more, and usually 12 or less, preferably 8.4 or less, more preferably 7.0 or less, still more preferably 6.0 or less, and especially preferably 5.0 or less. When the volume ratio, V(A)/V(B), is in the range described above, it is possible to improve the specific magnetic permeability, the loss factor, and the peelability.

The total amount (% by volume) of the nanocrystalline magnetic powder and the small-diameter magnetic powder included in the resin composition relative to 100% by volume of the non-volatile components in the resin composition may be expressed as "V(A) + V(B)". This total amount (% by volume), V(A) + V(B), is usually 28% by volume or more, preferably 34% by volume or more, more preferably 38% by volume or more, and especially preferably 40% by volume or more, and preferably 72% by volume or less, more preferably 68% by volume or less, still more preferably 64% by volume or less, and especially preferably 60% by volume or less. When the total amount (% by volume) of the nanocrystalline magnetic powder and the small-diameter magnetic powder, V(A) + V(B), is in the range described above, it is possible to improve the specific magnetic permeability, the loss factor, and the peelability.

Relative to 100 % by mass of the non-volatile components in the resin composition, the content (% by mass) of the nanocrystalline magnetic powder is represented by "M(A)" and the content (% by mass) of the small-diameter magnetic powder is represented by "M(B)". In this case, the mass ratio of the nanocrystalline magnetic powder to the small-diameter magnetic powder included in the resin composition ((A) nanocrystalline magnetic powder/(B) small-diameter magnetic powder) may be expressed as "M(A)/M(B)". This mass ratio M(A)/M(B) is preferably 1 or more, more preferably 3 or more, and especially preferably 5 or more, and preferably 15 or less, more preferably 10 or less, and especially preferably 9 or less. When the mass ratio M(A)/M(B) is in the range described above, it is possible to improve the specific magnetic permeability, the loss factor, and the peelability.

The total amount (% by mass) of the nanocrystalline magnetic powder and the small-diameter magnetic powder included in the resin composition may be expressed as "M(A) + M(B)" relative to 100% by mass of the non-volatile components in the resin composition. The total amount (% by mass), M(A) + M(B), is preferably 40% by mass or more, more preferably 45% by mass or more, still more preferably 50% by mass or more, and especially preferably 53% by mass or more, and preferably 95% by mass or less, more preferably 90% by mass or less, and especially preferably 88% by mass or less. When the total amount (% by mass), M(A) + M(B), is in the range described above, it is possible to improve the specific magnetic permeability, the loss factor, and the peelability.

The magnetic powder (C) may further include a magnetic powder that is different from the nanocrystalline magnetic powder and the small-diameter magnetic powder. The magnetic powder that is different from the nanocrystalline magnetic powder and the small-diameter magnetic powder is sometimes referred to as "intermediate magnetic powder".

The intermediate magnetic powder includes the following (C1) and (C2) magnetic powders.
(C1) Magnetic powder that is the nanocrystalline magnetic powder and has a particle size of more than 2 um and less than 5.5 µm.
(C2) Magnetic powder other than the nanocrystalline magnetic powder and has a particle size of more than 2 um and 20 um or less.

By including the intermediate magnetic powder in the resin composition, the ratio of the magnetic powder in the resin composition may be increased, so that the specific magnetic permeability of the cured product of the resin composition may be increased. Usually, the intermediate magnetic powder may increase the loss factor of the cured product, but the degree of the increase in the loss factor may be suppressed because the intermediate magnetic powder has a small particle size. Therefore, the intermediate magnetic powder may usually improve the specific magnetic permeability while suppressing the increase in the loss factor.

Specifically, the average particle diameter D₅₀ of the intermediate magnetic powder is usually more than 2 um, preferably 2.5 um or more, and more preferably 3 um or more, and usually less than the average particle diameter of the nanocrystalline magnetic powder, preferably less than 5.5 um, and more preferably 5 um or less. When the intermediate magnetic powder having the average particle diameter D₅₀ in the range described above is used, it is possible to improve the specific magnetic permeability, the loss factor, and the peelability. The average particle diameter D₅₀ of the intermediate magnetic powder represents the median diameter on a volume basis, and this may be measured by the same method as that for the average particle diameter D₅₀ of the nanocrystalline magnetic powder.

The volume-based particle size distribution of the intermediate magnetic powder usually follows a normal distribution. Thus, the intermediate magnetic powder may have a 10%-particle diameter D₁₀, which is smaller than the average particle diameter D₅₀ of the intermediate magnetic raw material powder, and a 90%-particle diameter D₉₀, which is larger than the average particle diameter D₅₀ of the intermediate magnetic powder. The 10%-particle diameter D₁₀ and the 90%-particle diameter D₉₀ of the intermediate magnetic raw material powder may be measured in the same way as the 10%-particle diameter D₁₀ and the 90%-particle diameter D₉₀ of the nanocrystalline magnetic powder.

The 10%-particle diameter D₁₀ of the intermediate magnetic powder is preferably 1 um or more, more preferably 1.3 um or more, and still more preferably 1.5 um or more. The upper limit thereof is equal to or less than the average particle diameter D₅₀, for example, 5 um or less, 4 um or less, and 3 um or less. When the 10%-particle diameter D₁₀ of the intermediate magnetic powder is in the range described above, it is possible to improve the specific magnetic permeability, the loss factor, and the peelability.

The 90%-particle diameter D₉₀ of the intermediate magnetic powder is preferably less than 10 um, more preferably 9 um or less, and especially preferably 8 um or less. The lower limit thereof is equal to or less than the average particle diameter D₅₀; thus, this may be, for example, 3 um or more, 4 um or more, and 5 µm or more. When the 90%-particle diameter D₉₀ of the intermediate magnetic powder is in the range described above, it is possible to improve the specific magnetic permeability, the loss factor, and the peelability.

The difference between the 10%-particle diameter D₁₀ and the 90%-particle diameter D₉₀ of the intermediate magnetic powder, i.e., D₉₀ - D₁₀, is preferably 0.1 um or more, more preferably 1 um or more, and especially preferably 2 um or more, and preferably 9 um or less, more preferably 7 um or less, and especially preferably 5 um or less. When the difference D₉₀ - D₁₀ is in the range described above, it is possible to improve the specific magnetic permeability, the loss factor, and the peelability.

The ratio of the 10%-particle diameter D₁₀ and the 90%-particle diameter D₉₀ of the intermediate magnetic powder, i.e., D₉₀/D₁₀, is preferably 1.1 or more, more preferably 1.5 or more, and especially preferably 2 or more, and preferably 10 or less, more preferably 8 or less, and especially preferably 6 or less. When the ratio D₉₀/D₁₀ is in the range described above, it is possible to improve the specific magnetic permeability, the loss factor, and the peelability.

The intermediate magnetic powder may be the nanocrystalline magnetic powder containing a crystalline particle, an amorphous magnetic powder not containing a crystalline particle, a crystalline magnetic powder other than the nanocrystalline magnetic powder, or a combination of these. The intermediate magnetic powder may be the magnetic material particle having the specific magnetic permeability of more than 1. The magnetic material described as the magnetic material of the small-diameter magnetic powder may be used as the magnetic material included in the intermediate magnetic powder. The magnetic material included in the intermediate magnetic powder and the magnetic material of the small-diameter magnetic powder may be the same or different. It is preferable that the intermediate magnetic powder includes the magnetic material described above, or includes only the magnetic material described above. In addition, the intermediate magnetic powder may be used singly or as a combination of two or more of those described above.

The intermediate magnetic powder that is commercially available may be used. Specific examples of the commercially available magnetic powder are the same as those for the small-diameter magnetic powder. When the intermediate magnetic powder is obtained from the market, commercially available magnetic powder may be used after having been classified, as needed.

The intermediate magnetic powder is preferably spherical. The range of the aspect ratio of the particle of the intermediate magnetic powder may be the same as the range of the aspect ratio of the nanocrystalline magnetic powder. The aspect ratio of the intermediate magnetic powder and the aspect ratio of the nanocrystalline magnetic powder may be the same or different. The aspect ratio of the intermediate magnetic powder and the aspect ratio of the small-diameter magnetic powder may be the same or different.

The content (% by volume) of the intermediate magnetic powder relative to 100% by volume of the non-volatile components in the resin composition may be 0% by volume, or more than 0% by volume; and it is preferably 1% by volume or more, more preferably 3% by volume or more, and especially preferably 5% by volume or more, and preferably 25% by volume or less, more preferably 15% by volume or less, and especially preferably 13% by volume or less. When the content of the intermediate magnetic powder is in the range described above, it is possible to improve the specific magnetic permeability, the loss factor, and the peelability.

The content (% by mass) of the intermediate magnetic powder relative to 100% by mass of the non-volatile components in the resin composition may be 0% by mass, or more than 0% by mass; and it is preferably 1% by mass or more, more preferably 5% by mass or more, and especially preferably 8% by mass or more, and preferably 20% by mass or less, more preferably 15% by mass or less, and still more preferably 10% by mass or less. When the content of the intermediate magnetic powder is in the range described above, it is possible to improve the specific magnetic permeability, the loss factor, and the peelability.

The content of the intermediate magnetic powder (% by volume) relative to 100 % by volume of the non-volatile components in the resin composition is expressed as "V(C)". In this case, the volume ratio of the nanocrystalline magnetic powder and the intermediate magnetic powder in the resin composition (intermediate magnetic powder/nanocrystalline magnetic powder) may be expressed as "V(C)/V(A)". The volume ratio, V(C)/V(A), may be 0, or more than 0, and this is preferably 0.01 or more, more preferably 0.1 or more, and preferably 1.0 or less, more preferably 0.9 or less, and especially preferably 0.8 or less. When the volume ratio, V(C)/V(A), is in the range described above, it is possible to improve the specific magnetic permeability, the loss factor, and the peelability.

The volume ratio of the small-diameter magnetic powder and the intermediate magnetic powder in the resin composition (intermediate magnetic powder/small-diameter magnetic powder) may be expressed as "V(C)/V(B)". This volume ratio, V(C)/V(B), may be 0, or more than 0, and this is preferably 0.01 or more, more preferably 0.1 or more, and preferably 8 or less, more preferably 5 or less, and especially preferably 2 or less. When the volume ratio, V(C)/V(B), is in the range described above, it is possible to improve the specific magnetic permeability, the loss factor, and the peelability.

The total content (% by volume) of the nanocrystalline magnetic powder, the small-diameter magnetic powder, and the intermediate magnetic powder relative to 100% by volume of the non-volatile components in the resin composition is preferably 70% by volume or more, more preferably 75% by volume or more, and especially preferably 80% by volume or more, and preferably 95% by volume or less, more preferably 90% by volume or less, and especially preferably 85% by volume or less. When the total content (% by volume) of the nanocrystalline magnetic powder, the small-diameter magnetic powder, and the intermediate magnetic powder is in the range described above, it is possible to improve the specific magnetic permeability, the loss factor, and the peelability.

The total content (% by volume) of the nanocrystalline magnetic powder, the small-diameter magnetic powder, and the intermediate magnetic powder relative to 100% by volume of the total content of the magnetic powders in the resin composition is preferably 50% by volume or more, more preferably 60% by volume or more, especially preferably 70% by volume or more, and usually 100% by volume or less. A larger value thereof indicates that there are fewer giant magnetic powders having the particle size of more than 20 um in the resin composition. When the total content (% by volume) of the nanocrystalline magnetic powder, the small-diameter magnetic powder, and the intermediate magnetic powder is in the range described above, it is possible to improve the specific magnetic permeability, the loss factor, and the peelability.

The content (% by mass) of the intermediate magnetic powder relative to 100% by mass of the non-volatile components in the resin composition is expressed as "M(C)". In this case, the mass ratio of the nanocrystalline magnetic powder and the intermediate magnetic powder in the resin composition (intermediate magnetic powder/nanocrystalline magnetic powder) may be expressed as "M(C)/M(A)". This mass ratio, M(C)/M(A), may be 0, or more than 0, and this is preferably 1 or more, more preferably 3 or more, and especially preferably 5 or more, and preferably 15 or less, more preferably 10 or less, and especially preferably 9 or less. When the mass ratio, M(C)/M(A), is in the range described above, it is possible to improve the specific magnetic permeability, the loss factor, and the peelability.

The mass ratio of the small-diameter magnetic powder and the intermediate magnetic powder in the resin composition (intermediate magnetic powder/small-diameter magnetic powder) may be expressed as "M(C)/M(B)". This mass ratio, M(C)/M(B), may be 0, or more than 0, and this is preferably 0.01 or more, more preferably 0.1 or more, and especially preferably 0.5 or more, and preferably 8 or less, more preferably 5 or less, and especially preferably 1.5 or less. When the mass ratio, M(C)/M(B), is in the range described above, it is possible to improve the specific magnetic permeability, the loss factor, and the peelability.

The total content (% by mass) of the nanocrystalline magnetic powder, the small-diameter magnetic powder, and the intermediate magnetic powder relative to 100% by mass of the non-volatile components in the resin composition is preferably 40% by mass or more, more preferably 50% by mass or more, and especially preferably 60% by mass or more, and preferably 99% by mass or less, and more preferably 98% by mass or less. When the total content (% by mass) of the nanocrystalline magnetic powder, the small-diameter magnetic powder, and the intermediate magnetic powder is in the range described above, it is possible to improve the specific magnetic permeability, the loss factor, and the peelability.

The total content (% by mass) of the nanocrystalline magnetic powder, the small-diameter magnetic powder, and the intermediate magnetic powder relative to 100% by mass of the total content of the magnetic powders in the resin composition is preferably 50% by mass or more, more preferably 60% by mass or more, especially preferably 70% by mass or more, and usually 1000 by mass or less. A larger value thereof indicates that there are fewer giant magnetic powders having the particle size of more than 20 um in the resin composition. When the total content (% by mass) of the nanocrystalline magnetic powder, the small-diameter magnetic powder, and the intermediate magnetic powder is in the range described above, it is possible to improve the specific magnetic permeability, the loss factor, and the peelability.

The content (% by volume) of the magnetic powder (C) relative to 100% by volume of the non-volatile components in the resin composition is preferably 70% by volume or more, preferably 75% by volume or more, and especially preferably 80% by volume or more, and preferably 95% by volume or less, more preferably 90% by volume or less, and especially preferably 85% by volume or less. When the content of the magnetic powder (C) is in the range described above, it is possible to improve the specific magnetic permeability, the loss factor, and the peelability.

The content (% by mass) of the magnetic powder (C) relative to 100% by mass of the non-volatile components in the resin composition is preferably 40% by mass or more, more preferably 50% by mass or more, and especially preferably 60% by mass or more, and preferably 99% by mass or less, and more preferably 98% by mass or less. When the content of the magnetic powder (C) is in the range described above, it is possible to improve the specific magnetic permeability, the loss factor, and the peelability.

### (D) Polymer Compound Having Weight-average Molecular Weight of 8000 or More

The resin composition may contain (D) a polymer compound having a weight-average molecular weight of 8000 or more as the component (D), in combination with the components (A) through (C). The polymer compound having a weight-average molecular weight of 8000 or more (D) as the component (D) does not include those that fall under the components (A) through (C) described above. The component (D), with which the cured product of the resin composition having an excellent peelability may be obtained by including the component (D) in the resin composition, may be used singly or in a combination of two or more kinds.

The weight-average molecular weight of the component (D) is 8000 or more, preferably 9000 or more, and still more preferably 10000 or more. The upper limit thereof is preferably 100000 or less, more preferably 50000 or less, and still more preferably 40000 or less.

As for the polymer compound having a weight-average molecular weight of 8000 or more (D), any of a thermosetting resin and a thermoplastic resin is preferable, and a thermoplastic resin is more preferable. Illustrative examples of the thermoplastic resin include a phenoxy resin, a polyvinyl acetal resin, a polyolefin resin, a polyimide resin, a polybutadiene resin, a polyamide imide resin, a polyether imide resin, a polysulfone resin, a polyether sulfone resin, a polyphenylene ether resin, a polyether ether ketone resin, and a polyester resin. Among these, a phenoxy resin is preferable.

Illustrative examples of the phenoxy resin include a phenoxy resin having one or more skeletons selected from the group consisting of a bisphenol A skeleton, a bisphenol F skeleton, a bisphenol S skeleton, a bisphenol acetophenone skeleton, a novolac skeleton, a biphenyl skeleton, a fluorene skeleton, a dicyclopentadiene skeleton, a norbornene skeleton, a naphthalene skeleton, an anthracene skeleton, an adamantane skeleton, a terpene skeleton, and a trimethylcyclohexane skeleton. The phenoxy resin may be terminated with any functional groups, such as a phenolic hydroxy group and an epoxy group. Specific examples of the phenoxy resin include "1256" and "4250" (both phenoxy resins containing a bisphenol A skeleton) manufactured by Mitsubishi Chemical Corp.; "YX8100" (phenoxy resin containing a bisphenol S skeleton) manufactured by Mitsubishi Chemical Corp.; "YX6954" (phenoxy resin containing a bisphenol acetophenone skeleton) manufactured by Mitsubishi Chemical Corp.; "FX280" and "FX293" manufactured by Nippon Steel Chemical & Material Co., Ltd.; and "YL7500BH30", "YX6954BH30", "YX7553", "YX7553BH30", "YL7769BH30", "YL6794", "YL7213", "YL7290", "YL7482", and "YL7891BH30", all being manufactured by Mitsubishi Chemical Corp.

Illustrative examples of the polyvinyl acetal resin include a polyvinylformal resin and a polyvinyl butyral resin; here, the polyvinyl butyral resin is preferable. Specific examples of the polyvinyl acetal resin include "Denka Butyral 4000-2", "Denka Butyral 5000-A", "Denka Butyral 6000-C", and "Denka Butyral 6000-EP", all of them being manufactured by Denka Company Ltd.; and the S-LEC BH series, the BX series (e.g., BX-5Z), the KS series (e.g., KS-1), the BL series, and the BM series, all of them being manufactured by Sekisui Chemical Co., Ltd.

Illustrative examples of the polyolefin resin include low-density polyethylene, ultra-low-density polyethylene, high-density polyethylene, ethylene copolymer resins such as ethylene-vinyl acetate copolymer, ethylene-ethyl acrylate copolymer, and ethylene-methyl acrylate copolymer; and polyolefin polymers such as polypropylene and ethylene-propylene block copolymer.

Specific examples of the polyimide resin include "SLK-6100" manufactured by Shin-Etsu Chemical Co., Ltd.; and "Rikacoat SN20" and "Rikacoat PN20" manufactured by New Japan Chemical Co., Ltd. Specific examples of the polyimide resin also include a linear polyimide obtained by reacting a bifunctional hydroxyl group-terminated polybutadiene, a diisocyanate compound, and a tetrabasic acid anhydride (polyimide described in Japanese Patent Application Laid-open No. 2006-37083), and modified polyimides such as the polyimides containing a polysiloxane skeleton (polyimides described in Japanese Patent Application Laid-open No. 2002-12667 and Japanese Patent Application Laid-open No. 2000-319386).

Illustrative examples of the polybutadiene resin include a resin containing a hydrogenated polybutadiene skeleton, a polybutadiene resin containing a hydroxy group, a polybutadiene resin containing a phenolic hydroxy group, a polybutadiene resin containing a carboxy group, a polybutadiene resin containing an acid anhydride group, a polybutadiene resin containing an epoxy group, a polybutadiene resin containing an isocyanate group, a polybutadiene resin containing a urethane group, and a polyphenylene ether-polybutadiene resin.

Specific examples of the polyamide imide resin include "Vyromax HR11NN" and "Vyromax HR16NN", both being manufactured by Toyobo Co., Ltd. Specific examples of the polyamide imide resin also include modified polyamide imides such as "KS9100" and "KS9300" (polyamide imide containing a polysiloxane skeleton) manufactured by Resonac Co., Ltd.

Specific examples of the polyethersulfone resin include "PES5003P" manufactured by Sumitomo Chemical Co., Ltd.

Specific examples of the polysulfone resin include polysulfone "P1700" and "P3500", both being manufactured by Solvay Advanced Polymers, LLC.

Specific examples of the polyphenylene ether resin include "NORYL SA90" manufactured by SABIC. Specific examples of the polyether imide resin include "Ultem" manufactured by GE.

Illustrative examples of the polycarbonate resin include a hydroxy group-containing carbonate resin, a phenolic hydroxy group-containing carbonate resin, a carboxy group-containing carbonate resin, an acid anhydride group-containing carbonate resin, an isocyanate group-containing carbonate resin, and a urethane group-containing carbonate resin. Specific examples of the polycarbonate resin include "FPC0220" manufactured by Mitsubishi Gas Chemical Company, Inc., "T6002" and "T6001" (polycarbonate diol) manufactured by Asahi Kasei; and "C-1090", "C-2090", and "C-3090" (polycarbonate diol) manufactured by Kuraray Co., Ltd. Specific examples of the polyether ether ketone resin include "Sumiploy K" manufactured by Sumitomo Chemical Co., Ltd.

Illustrative examples of the polyester resin include a polyethylene terephthalate resin, a polyethylene naphthalate resin, a polybutylene terephthalate resin, a polybutylene naphthalate resin, a polytrimethylene terephthalate resin, a polytrimethylene naphthalate resin, and a polycyclohexanedimethyl terephthalate resin.

The content of the component (D) relative to 100% by mass of the non-volatile components in the resin composition is preferably 5% by mass or less, more preferably 3% by mass or less, and still more preferably 2% by mass or less. The lower limit thereof is 0% by mass or more, 0.5% by mass or more, or the like, and it is especially preferable not to include this component.

Relative to 100% by mass of the non-volatile components in the resin composition, when the content of the component (A) is Am and the content of the component (D) is Dm, from the viewpoint of clearly obtaining the advantageous effects of the present invention, Dm/(Am + Dm) is preferably 0 or more, more preferably 0.1 or more, and still more preferably 0.2 or more, and preferably 0.7 or less, more preferably 0.6 or less, and still more preferably 0.55 or less.

Relative to 100% by mass of the non-volatile components in the resin composition, when the content of the component (A) is Am, the content of the component (B) is Bm, and the content of the component (D) is Dm, from the viewpoint of clearly obtaining the advantageous effects of the present invention, (Am + Dm)/(Am + Bm + Dm) is preferably 0.1 or more, more preferably 0.15 or more, and still more preferably 0.2 or more, and preferably 0.8 or less, more preferably 0.4 or less, and still more preferably 0.3 or less.

### (E) Solvent

The resin composition may further include (E) a solvent as a volatile component, in combination with the non-volatile components such as the components (A) through (D) described above.

An organic solvent is usually used as the solvent (E). Illustrative examples of the organic solvent include: ketone type solvents such as acetone, methyl ethyl ketone, methyl isobutyl ketone, and cyclohexanone; ester type solvents such as methyl acetate, ethyl acetate, butyl acetate, isobutyl acetate, isoamyl acetate, methyl propionate, ethyl propionate, γ-butyrolactone, and butyl carbitol acetate; ether type solvents such as tetrahydropyran, tetrahydrofuran, 1,4-dioxane, diethyl ether, diisopropyl ether, dibutyl ether, and diphenyl ether; alcohol type solvents such as methanol, ethanol, propanol, butanol, and ethyleneglycol; ether ester type solvents such as 2-ethoxyethyl acetate, propyleneglycol monomethyl ether acetate, diethyleneglycol monoethyl ether acetate, ethyldiglycol acetate, γ-butyrolactone, and methyl methoxypropionate; ester alcohol type solvents such as methyl lactate, ethyl lactate, and methyl 2-hydroxyisobutyrate; ether alcohol type solvents such as 2-methoxypropanol, 2-methoxyethanol, 2-ethoxyethanol, propyleneglycol monomethyl ether, and diethyleneglycol monobutyl ether (butyl carbitol); amide type solvents such as N,N-dimethylformamide, N,N-dimethylacetamide, and N-methyl-2-pyrrolidone; sulfoxide type solvents such as dimethyl sulfoxide; nitrile type solvents such as acetonitrile and propionitrile; aliphatic hydrocarbon type solvents such as hexane, cyclopentane, cyclohexane, and methylcyclohexane; and aromatic hydrocarbon type solvents such as benzene, toluene, xylene, ethylbenzene, and trimethylbenzene. Among these, a ketone type solvent and an ester type solvent are preferable as the solvent (E). The solvent (E) may be used singly or as a combination of two or more of those described above.

From the viewpoints of improving the peelability from the support in the resin sheet and of decreasing the tackiness of the resin composition layer, the amount of the solvent (E) relative to the total mass of the resin composition is preferably 0.5% by mass or more, more preferably 0.8% by mass or more, and still more preferably 1% by mass or more. From the viewpoint of easiness in coating by decreasing the viscosity of a resin varnish in the production of the resin sheet, the upper limit thereof is preferably 1.5% by mass or less, more preferably 1.4% by mass or less, and still more preferably 1.3% by mass or less.

### (F) Curing Agent

The resin composition may contain a curing agent (F) as the component (F), in combination with the components (A) through (C). The curing agent (F) as the component (F) does not include those that fall under the components (A) through (E) described above. In the curing agent (F), there are an epoxy resin curing agent that has the function to cure the epoxy resin (B) and a curing accelerator that has the function to accelerate the curing speed of the epoxy resin (B). The curing accelerator is usually used together with the epoxy resin curing agent. It is preferable that the resin composition includes the epoxy resin curing agent as the curing agent (F).

### Epoxy Resin Curing Agent

The epoxy resin curing agent is usually capable of curing the resin composition by reacting with the epoxy resin (B). Illustrative examples of the epoxy resin curing agent include a phenol type epoxy resin curing agent, a naphthol type epoxy resin curing agent, an active ester type epoxy resin curing agent, an acid anhydride type epoxy resin curing agent, a benzoxazine type epoxy resin curing agent, a cyanate ester type epoxy resin curing agent, and an imidazole type epoxy resin curing agent. As for the epoxy resin curing agent, one or more curing agents selected from a phenol type epoxy resin curing agent and a naphthol type epoxy resin curing agent are preferable, and a phenol type epoxy resin curing agent is more preferable. The epoxy resin curing agent may be used singly, or as a mixture of two or more kinds may be used in combination.

From the viewpoints of a heat resistance and a water resistance, a phenol type epoxy resin curing agent having a novolac structure or a naphthol type epoxy resin curing agent having a novolac structure is preferable as the phenol type epoxy resin curing agent and the naphthol type epoxy resin curing agent. As for the phenol type epoxy resin curing agent, a nitrogen-containing phenol type epoxy resin curing agent is preferable, and a phenol type epoxy resin curing agent containing a triazine skeleton is more preferable, and a phenolic novolac epoxy resin curing agent containing a triazine skeleton is still more preferable.

Specific examples of the phenol type epoxy resin curing agent and the naphthol type epoxy resin curing agent include: "MEH-7700", "MEH-7810", and "MEH-7851", all of which are manufactured by Meiwa Plastic Industries, Ltd.; "NHN", "CBN", and "GPH", all of which are manufactured by Nippon Kayaku Co., Ltd.; "SN170", "SN180", "SN190", "SN475", "SN485", "SN495V", "SN375", and "SN395", all of which are manufactured by Nippon Steel Sumikin Chemical Co., Ltd.; and "TD-2090", "LA-7052", "LA-7054", "LA-1356", "LA-3018-50P", "EXB-9500", "HPC-9500", "KA-1160, "KA-1163", and "KA-1165", all of which are manufactured by DIC Corp.; and "GDP-6115L" and "GDP-6115H", both of which are manufactured by Gun Ei Chemical Industry Co., Ltd.

There is no particular restriction in the active ester type epoxy resin curing agent. In general, compounds having two or more highly reactive ester groups in one molecule, including a phenol ester, a thiophenol ester, a N-hydroxyamine ester, and an ester of a heterocyclic hydroxy compound, are preferably used. The active ester type epoxy resin curing agents are preferably those obtained by a condensation reaction of a carboxylic acid compound and/or a thiocarboxylic acid compound with a hydroxy compound and/or with a thiol compound. In particular, from the viewpoint of enhancing a heat resistance, the active ester type epoxy resin curing agents obtained from a carboxylic acid compound and a hydroxy compound are preferable, while the active ester type epoxy resin curing agents obtained from a carboxylic acid compound and a phenol compound and/or a naphthol compound are more preferable. Illustrative examples of the carboxylic acid compound include benzoic acid, acetic acid, succinic acid, maleic acid, itaconic acid, phthalic acid, isophthalic acid, terephthalic acid, and pyromellitic acid. Illustrative examples of the phenol compound or the naphthol compound include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxy naphthalene, 1,6-dihydroxy naphthalene, 2,6-dihydroxy naphthalene, dihydroxy benzophenone, trihydroxy benzophenone, tetrahydroxy benzophenone, phloroglucin, benzene triol, a dicyclopentadiene type diphenol compound, and a phenol novolac. Here, the "dicyclopentadiene type diphenol compound" means a diphenol compound obtained by condensation of one dicyclopentadiene molecule with two phenol molecules.

Specifically, preferable are the active ester type epoxy resin curing agent containing a dicyclopentadiene type diphenol structure, the active ester type epoxy resin curing agent containing a naphthalene structure, the active ester type epoxy resin curing agent containing an acetylated phenol novolac, and the active ester type epoxy resin curing agent containing a benzoylated phenol novolac. Here, the "dicyclopentadiene type diphenol structure" means a divalent structure formed of phenylene-dicyclopentylene-phenylene.

Illustrative examples of commercially available products of the active ester type epoxy resin curing agent include: as the active ester type epoxy resin curing agent containing a dicyclopentadiene type diphenol structure, "EXB9451", "EXB9460", "EXB9460S", "HPC-8000-65T", "HPC-8000H-65TM", and "EXB-8000L-65TM", which are all manufactured by DIC Corp.; as the active ester compound containing a naphthalene structure, "EXB9416-70BK", which is manufactured by DIC Corp.; as the active ester type epoxy resin curing agent containing an acetylated phenol novolac, "DC808" manufactured by Mitsubishi Chemical Corp.; as the active ester type epoxy resin curing agent containing a benzoylated phenol novolac, "YLH1026", "YLH1030", and "YLH1048", which are all manufactured by Mitsubishi Chemical Corp.; and as the active ester type epoxy resin curing agent that is the acetylated phenol novolac, "DC808" manufactured by Mitsubishi Chemical Corp.

The acid anhydride type epoxy resin curing agent may be the epoxy resin curing agent having one or more acid anhydride groups in one molecule thereof. Specifically, illustrative examples of the acid anhydride type epoxy resin curing agent include phthalic anhydride, tetrahydrophthalic anhydride, hexahydrophthalic anhydride, methyltetrahydrophthalic anhydride, methylhexahydrophthalic anhydride, methylnadic anhydride, hydrogenated methylnadic anhydride, trialkyltetrahydrophthalic anhydride, dodecenylsuccinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphtho[1,2-C]furan-1,3-dione, ethyleneglycol bis(anhydrotrimellitate), and a polymer type acid anhydride such as a styrene-maleic acid resin, which is a copolymer of styrene and maleic acid.

Illustrative examples of commercially available products of the acid anhydride type epoxy resin curing agent include: "HNA-100" and "MH-700", which are manufactured by New Japan Chemical Co., Ltd.

Specific examples of the benzoxazine type epoxy resin curing agent include "HFB2006M" manufactured by Showa Highpolymer Co., Ltd., and "P-d" and "F-a", which are manufactured by Shikoku Chemicals Corp.

Illustrative examples of the cyanate ester type epoxy resin curing agent include bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl) thioether, and bis(4-cyanatephenyl) ether; polyfunctional cyanate resins derived from a phenol novolac, a cresol novolac, and the like; and a prepolymer in which these cyanate resins are partially made to triazine. Specific examples of the cyanate ester type epoxy resin curing agent include "PT30" and "PT60" (both are phenol novolac type polyfunctional cyanate ester resins); "BA230" and "BA230S75" (prepolymers in which part or all of bisphenol A dicyanate is made to triazine so as to be a trimer), all of these being manufactured by arxada Japan Ltd.

Illustrative examples of the imidazole type epoxy resin curing agent include imidazole compounds such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-bezyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-metylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrro[1,2-a]benzimidazole, 1-dodecyl-2-methyl-3-benzylimidazolium chloride, 2-methylimidazoline, and a 2-phenylimidazoline; and adducts of these imidazole compounds with an epoxy resin. Among these, 2-ethyl-4-methylimidazole and 1-benzyl-2-phenylimidazole are preferable.

Commercially available products may be used as the imidazole type epoxy resin curing agent. Illustrative examples thereof include "2MZA-PW" and "2PHZ-PW", which are manufactured by Shikoku Chemicals Corp., and "P200-H50" manufactured by Mitsubishi Chemical Corp.

The quantity ratio of the epoxy resin to the epoxy resin curing agent in terms of the ratio of [total number of the epoxy groups in the epoxy resins] to [total number of the reactive groups in the epoxy resin curing agents] is preferably in the range of 1:0.2 to 1:2, more preferably in the range of 1:0.3 to 1:1.5, and still more preferably in the range of 1:0.4 to 1:1. Note that the reactive group of the epoxy resin curing agent means an active hydroxy group, an active ester group, and the like, and these are different depending on the type of the epoxy resin curing agent. The total number of the epoxy groups in the epoxy resin means the total value of the values for all epoxy resins, obtained by dividing the mass of the non-volatile components in each epoxy resin by the epoxy equivalent. The total number of the reactive groups in the epoxy resin curing agent means the total value of the values for all epoxy resin curing agents, obtained by dividing the mass of the non-volatile components in each epoxy resin curing agent by the equivalent of the reactive group. When the quantity ratio of the epoxy resin to the epoxy resin curing agent is brought into this range, the heat resistance of the cured product obtained thereby is enhanced further.

The content of the epoxy resin curing agent relative to 100% by mass of the non-volatile components in the resin composition is preferably 0.1% by mass or more, more preferably 0.5% by mass or more, and still more preferably 0.8% by mass or more; and the upper limit thereof is preferably 8% by mass or less, more preferably 3% by mass or less, and still more preferably 2% by mass or less.

### Curing Accelerator

A curing accelerator usually acts as the catalyst of the curing reaction of the epoxy resin (B) so that the curing reaction may be accelerated. Illustrative examples of the curing accelerator include an amine type curing accelerator, an imidazole type curing accelerator, a phosphorous type curing accelerator, a guanidine type curing accelerator, and a metal type curing accelerator. The curing accelerator may be used singly, or as a combination of two or more of those described above. The curing accelerator is generally used in combination with the epoxy resin curing agent.

Illustrative examples of the amine type curing accelerator include: trialkylamines such as triethylamine and tributylamine; and 4-dimethylaminopyridine, benzyl dimethyl amine, 2,4,6-tris(dimethylaminomethyl)phenol, and 1,8-diazabicyclo(5,4,0)-undecene. Among these, 4-dimethylaminopyridine and 1,8-diazabicyclo(5,4,0)-undecene are preferable.

Commercially available products may be used as the amine type curing accelerator. Illustrative examples thereof include "PN-50", "PN-23", and "MY-25", which are all manufactured by Ajinomoto Fine-Techno Co., Inc.

The imidazole type curing accelerator is the same as the imidazole type epoxy resin curing agent described above. The imidazole type epoxy resin curing agent may function also as the curing accelerator when used in combination with other epoxy resin curing agent.

Illustrative examples of the phosphorous type curing agent include triphenyl phosphine, a phosphonium borate compound, tetraphenyl phosphonium tetraphenyl borate, n-butyl phosphonium tetraphenyl borate, tetrabutyl phosphonium decanoate salt, (4-methylphenyl) triphenyl phosphonium thiocyanate, tetraphenyl phosphonium thiocyanate, and butyl triphenyl phosphonium thiocyanate. Among these, triphenyl phosphine and tetrabutyl phosphonium decanoate salt are preferable.

Commercially available products may be used as the phosphorous type curing accelerator. Illustrative examples thereof include "TBP-DA" manufactured by HOKKO CHEMICAL INDUSTRY CO., LTD.

Illustrative examples of the guanidine type curing accelerator include dicyandiamide, 1-methyl guanidine, 1-ethyl guanidine, 1-cyclohexyl guanidine, 1-phenyl guanidine, 1-(o-tolyl) guanidine, dimethyl guanidine, diphenyl guanidine, trimethyl guanidine, tetramethyl guanidine, pentamethyl guanidine, 1,5,7-triazabicyclo[4.4.0]deca-5-ene, 7-methyl-1,5,7-triazabicyclo[4.4.0]deca-5-ene, 1-methyl biguanide, 1-ethyl biguanide, 1-n-butyl biguanide, 1-n-octadecyl biguanide, 1,1-dimethyl biguanide, 1,1-diethyl biguanide, 1-cyclohexyl biguanide, 1-allyl biguanide, 1-phenyl biguanide, and 1-(o-tolyl) biguanide. Among these, dicyandiamide and 1,5,7-triazabicyclo[4.4.0]deca-5-ene are preferable.

Illustrative examples of the metal type curing accelerator include organic metal complexes or organic metal salts of metals such as cobalt, copper, zinc, iron, nickel, manganese, and tin. Specifically, illustrative examples of the organometallic complex include organic cobalt complexes such as cobalt (II) acetylacetonate and cobalt (III) acetylacetonate; organic copper complexes such as copper (II) acetylacetonate; organic zinc complexes such as zinc (II) acetylacetonate; organic iron complexes such as iron (III) acetylacetonate; organic nickel complexes such as nickel (II) acetylacetonate; and organic manganese complexes such as manganese (II) acetylacetonate. Illustrative examples of the organic metal salt include zinc octylate, tin octylate, zinc naphthenate, cobalt naphthenate, tin stearate, and zinc stearate.

The content of the curing accelerator relative to 100% by mass of the non-volatile components in the resin composition is preferably 0.001% by mass or more, more preferably 0.005% by mass or more, and still more preferably 0.01% by mass or more; and the upper limit thereof is preferably 2% by mass or less, more preferably 0.1% by mass or less, and still more preferably 0.05% by mass or less.

The content of the curing agent (F) relative to 100% by mass of the non-volatile components in the resin composition is preferably 0.1% by mass or more, more preferably 0.5% by mass or more, and still more preferably 0.8% by mass or more; and the upper limit thereof is preferably 8% by mass or less, more preferably 4% by mass or less, and still more preferably 3% by mass or less.

### (G) Dispersant

The resin composition may contain a dispersant (G) as the component (G), in combination with the components (A) thorough (F). The dispersant (G) as the component (G) does not include those that fall under the components (A) through (F) described above. Together with the dispersant (G), the dispersibility of the magnetic powder (C) may be effectively enhanced, so that the viscosity of the resin composition may be effectively lowered; as a result, it is possible to improve the peelability. The dispersant (G) may be used singly or as a combination of two or more kinds.

There is no restriction in the dispersant (G). As for the dispersant (G), for example, the dispersant that contains a functional group having an adsorption ability for the magnetic powder (C) and that disperses magnetic powder (C) by repulsion (for example, electrostatic repulsion and steric repulsion) between the dispersants (G) when adsorbed onto the magnetic powder (C) may be used. Illustrative examples of such dispersant (G) include an acidic dispersant and a basic dispersant.

The acidic dispersant usually contains an acidic functional group such as a carboxyl group, a sulfo group (-SO₃H), a sulfate group (-OSO₃H), a phosphono group (-PO(OH)₂), a phosphonooxy group (-OPO(OH)₂), a hydroxyphosphoryl group (-PO(OH)-), and a sulfanyl group (-SH). The acidic functional group usually has a dissociable proton and may be neutralized by a base such as an amine and a hydroxide ion. Illustrative examples of the preferable acidic dispersant include an acidic polymer dispersant containing a polymer chain such as a polyoxyalkylene chain and a polyether chain. Preferable examples of the acidic dispersant include "C-2093I" and "SC-1015F (multifunctional comb-type functional polymer having an ionic group in the main chain and a polyoxyalkylene chain in the graft chain)" manufactured by NOF Corp.; "DA-375 (polyether phosphate ester compound type dispersant)" manufactured by Kusumoto Chemicals, Ltd.; "RS-410", "RS-610", and "RS-710" (pH: 1.9) of the "Phosphanol" series manufactured by TOHO Chemical Industry Co., Ltd.; and "AKM-0531", "AFB-1521", "SC-0505K", and "SC-0708A" of the "Malialim" series manufactured by NOF Corp.

The basic dispersant usually contains a basic functional group such as a primary, a secondary, and a tertiary amino group; an ammonium group; an imino group; and a nitrogen-containing heterocyclic group such as pyridine, pyrimidine, pyrazine, imidazole, and triazole. The basic functional group may be neutralized by an acid such as an organic acid or an inorganic acid. Preferable examples of the basic dispersant include a basic polymer dispersant containing a polymer chain such as a polyester chain. Preferable examples of the basic dispersant include "Ajisper PB881" (polyamine type dispersant containing a polyester chain) manufactured by Ajinomoto Fine-Techno Co., Inc.

The content of the dispersant (G) relative to 100% by mass of the non-volatile components in the resin composition may be 0% by mass, or more than 0% by mass; and it is preferably 0.05% by mass or more, and more preferably 0.1% by mass or more, and preferably 5% by mass or less, more preferably 3% by mass or less, and especially preferably 1% by mass or less. When the content of the dispersant (G) is in the range described above, the viscosity of the resin composition may be lowered, so that the peelability thereof may be improved.

### (H) Other Additive

The resin composition may include other additive (H) as an arbitrary non-volatile component. Illustrative examples of the other additive (H) include: a radically polymerizable compound; a polymerization initiator; an organometallic compound such as an organic copper compound, an organic zinc compound, and an organic cobalt compound; a coloring agent such as a phthalocyanine blue, a phthalocyanine green, an iodine green, a diazo yellow, a crystal violet, titanium oxide, and carbon black; polymerization inhibitors such as hydroquinone, catechol, pyrogallol, and phenothiazine; leveling agents such as a silicone type leveling agent and an acrylic polymer type leveling agent; thickeners such as bentone and montmorillonite; antifoaming agents such as a silicone type antifoaming agent, an acrylic type antifoaming agent, a fluorine type antifoaming agent, and a vinyl resin type antifoaming agent; UV absorbers such as a benzotriazole type UV absorber; adhesion enhancers such as a urea silane; adhesion assisting agents such as a triazole type adhesion assisting agent, a tetrazole type adhesion assisting agent, and a triazine type adhesion assisting agent; antioxidants such as a hindered phenol type antioxidant; fluorescent whitening agents such as a stilbene derivative; surfactants such as a fluorine type surfactant and a silicone type surfactant; flame retardants such as phosphorous type flame retardants (for example, a phosphate ester compound, a phosphazene compound, a phosphinate compound, and red phosphorus), nitrogen type flame retardants (for example, melamine sulfate), halogen type flame retardants, and inorganic type flame retardants (for example, antimony trioxide); stabilizers such as a borate-type stabilizer, a titanate type stabilizer, an aluminate type stabilizer, a zirconate type stabilizer, an isocyanate type stabilizer, a carboxylate type stabilizer, and a carboxylic acid anhydride type stabilizer; a photo polymerization assisting agent such as a tertiary amine; a photosensitizer such as a pyrazoline, an anthracene, a coumarin, a xanthone, and a thioxanthone. The other additive (H) may be used singly or as a combination of two or more of those described above.

### Physical Properties and the Like of Resin Composition

The resin composition exhibits the characteristic of an excellent peelability because it contains the component (A). Therefore, in the resin sheet containing the resin composition, when the support is peeled off from the resin composition layer, peeling off of the resin composition layer together with the support is suppressed. For example, when the resin sheet is peeled off from the support, whole of the resin composition layer may be peeled off from the support, and whole or part of the resin composition layer is not peeled off together with the support. Evaluation of the peelability may be measured by the method described in the examples to be described later.

The cured product obtained by heating the resin composition at 190°C for 90 minutes exhibits the characteristic of a high specific magnetic permeability at a frequency of 10 MHz. Accordingly, the cured product may provide the magnetic layer with a high specific magnetic permeability. The specific magnetic permeability of this cured product at a frequency of 10 MHz is preferably 29 or more, and more preferably 30 or more. Although the upper limit thereof is not particularly restricted, this may be made, for example, 100 or less. The specific magnetic permeability may be measured by the method described in the examples to be described later.

The cured product obtained by heating the resin composition at 190°C for 90 minutes exhibits the characteristic of a low loss factor at a frequency of 10 MHz. Accordingly, the cured product may provide the magnetic layer with a low loss factor. The loss factor of the cured product at a frequency of 10 MHz is preferably 0.4 or less, more preferably 0.3 or less, and still more preferably 0.2 or less. Although the lower limit thereof is not particularly restricted, this may be made, for example, 0.001 or more. The loss factor may be measured by the method described in the examples to be described later.

Usually, the resin composition has the characteristic of a low melt viscosity. The melt viscosity is preferably 10² poise or more, more preferably 10³ poise or more, and still more preferably 10⁴ poise or more, and preferably 10⁷ poise or less, more preferably 10⁶ poise or less, and still more preferably 10⁵ poise or less. The melt viscosity may be measured by the method described in the examples to be described later.

From the viewpoint of utilizing the advantages described above, it is preferable to use the resin composition for forming the magnetic layer of a circuit board. From the viewpoint of utilizing the advantages described above, it is preferable to use the resin composition for filling the through hole in the core substrate.

### Resin Sheet

The resin sheet includes a support and a resin composition layer formed on the support, the resin composition layer being formed of the resin composition according to the present invention.

From the viewpoint of thinning, the thickness of the resin composition layer is preferably 5 um or more, more preferably 10 um or more, and especially preferably 50 um or more, and preferably 600 um or less, more preferably 300 um or less, and especially preferably 200 um or less.

Illustrative examples of the support include a film formed of a plastic material, metal foil, and releasing paper. Among these, a film formed of a plastic material and metal foil are preferable.

When the film formed of a plastic material is used as the support, illustrative examples of the plastic material include polyesters such as polyethylene terephthalate (hereinafter, sometimes this is simply called "PET") and polyethylene naphthalate (hereinafter, sometimes this is simply called "PEN"); polycarbonate (hereinafter, sometimes this is simply called "PC"); acrylic polymers such as polymethyl methacrylate (PMMA); a cyclic polyolefin; triacetyl cellulose (TAC); polyether sulfide (PES); polyether ketone; and polyimide. Among these, polyethylene terephthalate and polyethylene naphthalate are preferable, while inexpensive polyethylene terephthalate is especially preferable.

In the case that metal foil is used as the support, illustrative examples of the metal foil include copper foil and aluminum foil, and copper foil is preferable. As for the copper foil, foil formed of a copper single metal or foil formed of an alloy of copper with other metals (for example, tin, chromium, silver, magnesium, nickel, zirconium, silicon, and titanium) may be used.

The support may be mat-treated or corona-treated on the surface to be bonded with the resin composition layer.

As for the support, a releasing layer-attached support having a releasing layer on the surface to be bonded with the resin composition layer may be used. The releasing agent to be used in the releasing layer of the releasing layer-attached support may be one or more releasing agents selected from the group consisting of, for example, an alkyd resin, a polyolefin resin, a urethane resin, and a silicone resin. A commercially available product may also be used as the releasing layer-attached support. Illustrative examples thereof include a PET film having a releasing layer mainly formed of an alkyd resin type releasing agent, such as "PET501010", "SK-1", "AL-5", and "AL-7", which are all manufactured by Lintech Corp.; "Lumirror T60" manufactured by Toray Industries, Inc.; "Purex" manufactured by Teijin Ltd.; and "Unipeel" manufactured by Unitika Ltd.

Although the thickness of the support is not particularly restricted, the thickness is preferably in the range of 5 um to 75 µm, and more preferably in the range of 10 um to 60 um. When the releasing layer-attached support is used, total thickness of the releasing layer-attached support is preferably in the range described above.

The resin sheet may be produced, for example, by forming a resin composition layer by applying a resin composition onto the support by means of a die coater or the like. As needed, the resin composition is dissolved into a solvent to prepare a resin varnish; and then, this resin varnish may be applied onto the support. When the solvent is used, as needed, drying may be carried out after the application.

Drying may be carried out by heating, blowing of hot air, or the like. The drying condition is not particularly restricted. The drying is carried out under the drying condition so as to bring the content of the organic solvent in the resin composition layer to 10% by mass or less, and preferably 5% by mass or less. The resin composition layer may be formed by drying at 50°C to 150°C for 3 minutes to 10 minutes, although the condition is different depending on the components included in the resin composition.

In the resin sheet, a protection film compatible with the support may be further laminated on the surface of the resin composition layer not bonded to the support (namely, on the surface opposite to the support). Although thickness of the protection film is not particularly restricted; for example, this is in the range of 1 um to 40 um. By laminating the protection film, the surface of the resin composition layer may be prevented from attachment of dirt and the like as well as from a scar formation. The resin sheet may be rolled up so as to be stored. When the resin sheet has the protection film, the resin sheet becomes usable by removing the protection film.

### Circuit Board and Producing Method Thereof

A circuit board according to one embodiment of the present invention includes the magnetic layer. This magnetic layer contains the cured product of the resin composition described above, or the cured product of the resin composition layer of the resin sheet; and it is preferable that the magnetic layer contains only the cured product of the resin composition described above. A specific structure of the circuit board is not restricted as long as the magnetic layer containing the cured product of the resin composition described above is provided. A circuit board according to a first embodiment is a circuit board having a core substrate as the substrate formed with a through hole and a magnetic layer filled in this through hole. A circuit board according to a second embodiment is a circuit board including a magnetic layer formed of the cured product of the resin composition layer in the resin sheet. In these circuit boards, the magnetic layer may be the cured product of the resin composition layer, and may be the cured product of the resin composition. Hereinafter, the first embodiment and the second embodiment with regard to the circuit board producing method will be explained. Note that the circuit board producing method relating to the present invention is not limited to the first embodiment and the second embodiment exemplified below.

### First Embodiment

The circuit board according to the first embodiment has the core substrate formed with the through hole and the magnetic layer filled in this through hole. This circuit board producing method includes, for example, the following steps in this order:
(1) laminating a core substrate formed with a through hole and a resin sheet such that the resin composition layer is filled in the through hole, and
(2) curing the resin composition layer to form a magnetic layer.

The circuit board producing method according to the first embodiment may also include an arbitrary step in combination with the above steps (1) through (2). For example, the circuit board producing method may include the steps of
(3) polishing the magnetic layer,
(4) applying a roughening treatment to the magnetic layer, and
(5) forming a conductive layer on the magnetic layer. Usually, the step (3), the step (4), and the step (5) are performed in this order.

### Step (1)

Step (1) usually includes preparing the core substrate formed with the through hole. The core substrate may be prepared by purchasing from the market. Alternatively, the core substrate may be prepared by production using a suitable material. Hereinafter, the producing method of the core substrate according to one example will be described.

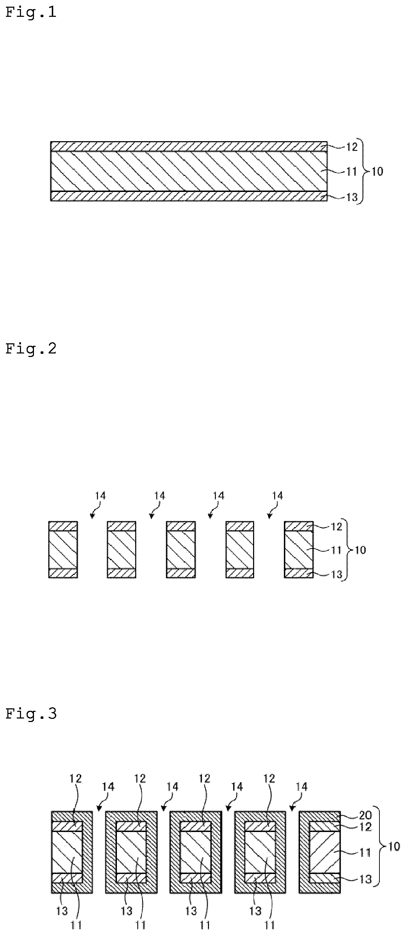

Fig. 1 is a schematic sectional view illustrating a core substrate 10 before forming a through hole in the circuit board producing method according to the first embodiment of the present invention. A step of preparing the core substrate 10 may include preparing the core substrate 10 not formed with the through hole to be filled with the magnetic layer, as illustrated in Fig. 1. This core substrate 10 is the substrate before forming the through hole; here, this may be a plate-like member.

The core substrate 10 usually includes a supporting substrate 11. Illustrative examples of the supporting substrate 11 include insulating substrates such as a glass epoxy substrate, a metal substrate, a polyester substrate, a polyimide substrate, a BT resin substrate, and a thermosetting type polyphenylene ether substrate. Also, on the supporting substrate 11, a metal layer may be formed. The metal layer may be formed on one surface of the supporting substrate 11, or on both the surfaces thereof. Here, the example is illustrated in which a metal layer 12 and a metal layer 13 are formed on both the surfaces of the supporting substrate 11. The metal layers 12 and 13 may be the layers formed by a metal such as copper. The metal layers 12 and 13 may be, for example, copper foil such as carrier-attached copper foil, or a metal layer formed of the material of the conductive layer that is going to be described later.

Fig. 2 is a schematic sectional view illustrating the core substrate 10 formed with a through hole 14 in the circuit board producing method according to the first embodiment of the present invention. As illustrated in Fig. 2, the step of preparing the core substrate 10 may include forming the through hole 14 in the core substrate 10. The through hole 14 may be formed, for example, by drilling, laser irradiation, or plasma irradiation. The through hole 14 may usually be formed by forming a penetrating hole through the core substrate 10. Specifically, formation of the through hole 14 may be carried out by using a drilling machine that is commercially available. Illustrative examples of the commercially available drilling machine include "ND-1S211" manufactured by Hitachi Via Mechanics, Ltd.

Fig. 3 is a schematic sectional view illustrating the core substrate 10 formed with a plated layer 20 in the through hole 14 in the circuit board producing method according to the first embodiment of the present invention. After the core substrate 10 is roughened as needed, the step of preparing the core substrate 10 may include forming the plated layer 20, as illustrated in Fig. 3. As the roughening treatment, any of a dry roughening treatment and a wet roughening treatment may be carried out. Examples of the dry roughening treatment include a plasma treatment. An example of the wet roughening treatment may include a method in which a swelling treatment by a swelling liquid, a roughening treatment by an oxidant, and a neutralizing treatment by a neutralizing solution are carried out in this order. The plated layer 20 may be formed by a plating method. The procedure to form the plated layer 20 by the plating method may be the same as that in formation of the conductive layer at step (5) that is going be described later. Here, the explanation will be made as to the example in which the plated layer 20 is formed inside the through hole 14, on the surface of the metal layer 12, and on the surface of the metal layer 13. In this example, the core substrate formed with the plated layer 20 is described with the same sign "10" as the sign of the core substrate 10 before forming the plated layer 20.

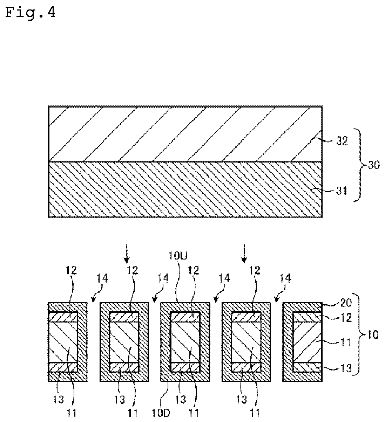

Fig. 4 is a schematic sectional view illustrating the state of the lamination of the core substrate 10 with a resin sheet 30 in the circuit board producing method according to the first embodiment of the present invention. As illustrated in Fig. 4, the step (1) includes, after the core substrate 10 formed with the through hole 14 is prepared, laminating the core substrate 10 with the resin sheet 30. In this embodiment, the example of laminating the resin sheet 30 having a resin composition layer 31 and a support 32 on one surface 10U of the core substrate 10 is illustrated. In the following description, the surface 10U of the core substrate 10 that is bonded to the resin sheet 30 is sometimes referred to as "first surface 10U" and the opposite surface as "second surface 10D".

Lamination of the core substrate 10 with the resin sheet 30 is performed such that part or whole of the resin composition layer 31 is filled in the through hole 14. Therefore, lamination is usually performed so that the resin composition layer 31 and the core substrate 10 is bonded. Specifically, the aforementioned lamination may be performed by bonding the resin composition layer 31 to the core substrate 10 by hot-pressing the resin sheet 30 to the core substrate 10. When the resin sheet 30 has the support 32, as in the example illustrated in Fig. 4, the aforementioned lamination may be done by pressing the resin sheet 30 from the side of the support 32 onto the core substrate 10. Illustrative examples of the hot-pressing member (hereinafter, this member (not in the drawing) is sometimes referred to as "hot-pressing member") include a heated metal plate (stainless steel (SUS) mirror plate and the like) and a heated metal roll (SUS roll). Here, the hot-pressing member may be pressed directly to the resin sheet 30, and it is preferable that the pressing is made via an elastic material such as a heat-resistant rubber in such a way that the resin sheet 30 well follows the surface irregularity of the core substrate 10.

Lamination of the core substrate 10 with the resin sheet 30 may be conducted, for example, by a vacuum lamination method. Lamination conditions may be, for example, as follows. The hot-pressing temperature is preferably in the range of 60°C to 160°C, and more preferably in the range of 80°C to 140°C. The pressure of the hot-pressing is preferably in the range of 0.098 MPa to 1.77 MPa, and more preferably 0.29 MPa to 1.47 MPa. The period of the hot-pressing is preferably in the range of 20 seconds to 400 seconds, and more preferably in the range of 30 seconds to 300 seconds. The lamination is carried out under a reduced pressure, preferably 13 hPa or less.

After the lamination, the laminated resin sheet 30 may be flattened by pressing the hot-pressing member from the side of the support 32 under a normal pressure (under an atmospheric pressure). The pressing conditions of the flattening may be the same as the hot-pressing conditions in the before-mentioned lamination. Note that the lamination and the flattening may be carried out continuously by using a vacuum laminator.

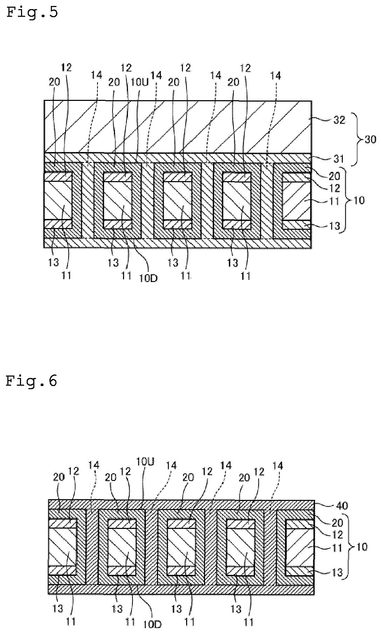

Fig. 5 is a schematic sectional view illustrating the state of the lamination of the core substrate 10 with the resin sheet 30 in the circuit board producing method according to the first embodiment of the present invention. The lamination of the core substrate 10 with the resin sheet 30 causes the resin composition layer 31 of the resin sheet 30 to enter into the through hole 14, as illustrated in Fig. 5, so that the through hole 14 is filled with the resin composition layer 31. Here, the example will be described in which a part of the resin composition layer 31 enters into the through hole 14, and another part does not enter into the through hole 14, thereby adhering to the first surface 10U of the core substrate 10. Thus, the resin composition layer 31 may be formed on the first surface 10U of the core substrate 10. In addition, a part of the resin composition layer 31 that has entered into the through hole 14 may pass through the through hole 14 and be dispensed from an opening on the side of the second surface 10D of the core substrate 10. Therefore, the resin composition layer 31 may be formed on the second surface 10D of the core substrate 10.

Usually, the support 32 is removed after the lamination of the core substrate 10 with the resin sheet 30. In this embodiment, the example in which the support 32 is removed after lamination of the core substrate 10 with the resin sheet 30 and before step (2) is illustrated and explained. However, removal of the support 32 may be performed after the step (2).

### Step (2)

Fig. 6 is a schematic sectional view to explain the step (2) in the circuit board producing method according to the first embodiment of the present invention. The step (2) includes curing the resin composition layer 31 after laminating the core substrate 10 with the resin sheet 30, as illustrated in Fig. 6. By curing the resin composition layer 31, a magnetic layer 40 containing the cured product of the resin composition may be formed. The magnetic layer 40 may be formed in the through hole 14 and also usually on the first surface 10U and the second surface 10D of the core substrate 10.

Curing of the resin composition layer 31 is usually carried out by thermal curing. Conditions of the thermal curing of the resin composition layer 31 may be set as appropriate so far as the resin composition layer 31 is cured. The curing temperature is preferably 60°C or higher, more preferably 70°C or higher, and still more preferably 80°C or higher, and preferably 245°C or lower, more preferably 220°C or lower, and still more preferably 200°C or lower. The curing period is preferably 5 minutes or longer, more preferably 10 minutes or longer, and still more preferably 15 minutes or longer, and preferably 120 minutes or shorter, more preferably 110 minutes or shorter, and still more preferably 100 minutes or shorter.

The curing degree of the magnetic layer 40 that is obtained at the step (2) is preferably 80% or more, more preferably 85% or more, and still more preferably 90% or more. The curing degree may be measured by using, for example, a differential scanning calorimeter.

The circuit board producing method may include, after the core substrate 10 is laminated with the resin sheet 30 and before the resin composition layer 31 is cured, a step at which the resin composition layer 31 is heated at a temperature lower than the curing temperature thereof (preliminary heating step). For example, before curing the resin composition layer 31, the resin composition layer 31 may be preliminarily heated usually at 50°C or higher and lower than 120°C (preferably 60°C or higher and 110°C or lower, more preferably 70°C or higher and 100°C or lower) for the period of usually 5 minutes or longer (preferably 5 minutes to 150 minutes, more preferably 15 minutes to 120 minutes).

### Step (3)

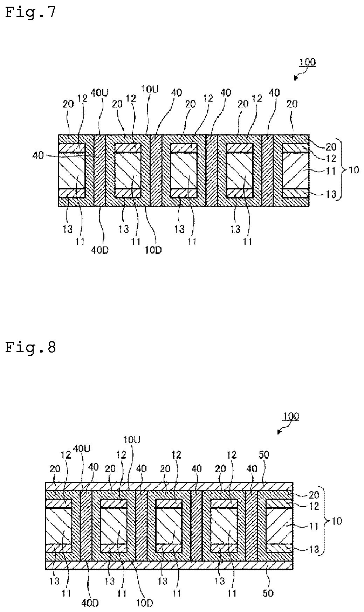

Fig. 7 is a schematic sectional view to explain step (3) in the circuit board producing method according to the first embodiment of the present invention. The step (3) may include polishing the magnetic layer 40. Specifically, the step (3) may include polishing the magnetic layer 40 in the area outside the through hole 14. In the example illustrated in this embodiment, the magnetic layer 40 is formed on the first surface 10U and the second surface 10D of the core substrate 10, so that the magnetic layer 40 in the portions on those first surface 10U and the second surface 10D may be polished. The portion of the magnetic layer 40 outside of the through hole 14 is generally a surplus portion that is not needed in the final product. The aforementioned polishing may remove the surplus portion, as illustrated in Fig. 7. The polishing may also flatten polished surfaces 40U and 40D as the surfaces of the magnetic layer 40.

As for the polishing method, a method with which an unnecessary portion of the magnetic layer 40 may be removed may be employed. Illustrative examples of such a polishing method include a buff polishing method, a belt polishing method, and a ceramic polishing method. Illustrative examples of the buff polishing equipment that is commercially available include "NT-700IM" manufactured by Ishiihyoki Co., Ltd.

From the viewpoint of enhancing the adhesion with the conductive layer (not illustrated in Fig. 7), the arithmetic average roughness (Ra) of the polished surfaces 40U and 40D of the magnetic layer 40 is preferably 300 nm or more, more preferably 350 nm or more, and still more preferably 400 nm or more. The upper limit thereof is preferably 1000 nm or less, more preferably 900 nm or less, and still more preferably 800 nm or less. The surface roughness (Ra) may be measured, for example, by using a non-contact type surface roughness meter.

After the step (2) and before step (3), the magnetic layer 40 may be heat treated to further increase the curing degree of the magnetic layer 40. As for the temperature at this heat treatment, the above-mentioned curing temperature may be applied. Specifically, the temperature at the heat treatment is preferably 120°C or higher, more preferably 130°C or higher, and still more preferably 150°C or higher, and preferably 245°C or lower, more preferably 220°C or lower, and still more preferably 200°C or lower. The heat-treatment period is preferably 5 minutes or longer, more preferably 10 minutes or longer, and still more preferably 15 minutes or longer, and preferably 150 minutes or shorter, more preferably 120 minutes or shorter, and still more preferably 100 minutes or shorter.

By performing the steps (1) and (2) described above and further performing the step (3) as needed, a circuit board 100 having the core substrate 10 and the magnetic layer 40 filled in the through holes 14 of the core substrate 10 may be obtained. The circuit board 100 thus obtained may be subjected to step (4) and step (5) to form a conductive layer, as needed.

### Step (4)

The step (4) includes performing roughning on the magnetic layer. Usually, the roughning treatment is applied to the polished surface of the magnetic layer. At the step (4), not only the polished surface of the magnetic layer but also the surfaces 10U and 10D of the core substrate 10 may be subjected to the roughening treatment.

The procedure and condition of the roughening treatment are not particularly restricted; for example, the procedure and condition that are used in the producing method of a multilayer printed wiring board may be used. Specifically, the sparse treatment may be carried out by the method including a swelling treatment with a swelling liquid, a roughening treatment with an oxidant, and a neutralization treatment with a neutralizing solution in this order.

Illustrative examples of the swelling liquid that may be used in the swelling treatment include an alkaline solution and a surfactant solution; here, an alkaline solution is preferable. As for the alkaline solution as the swelling liquid, a sodium hydroxide solution and a potassium hydroxide solution are more preferable. Illustrative examples of the swelling liquid that is commercially available include "Swelling Dip Securiganth P" and "Swelling Dip Securiganth SBU", which are both manufactured by Atotech Japan K.K.

The swelling treatment with the swelling liquid may be carried out, for example, by soaking the magnetic layer into the swelling liquid at 30°C to 90°C for the period of 1 minute to 20 minutes. From the viewpoint of suppressing swelling of the resin in the magnetic layer to a suitable level, it is preferable that the magnetic layer is soaked into the swelling liquid at 40°C to 80°C for the period of 5 minutes to 15 minutes.

As for the oxidant that can be used in the roughening treatment, illustrative examples thereof include an alkaline permanganate solution having potassium permanganate or sodium permanganate dissolved into a sodium hydroxide aqueous solution. The roughening treatment using the oxidant such as the alkaline permanganate solution is carried out preferably by soaking the magnetic layer into the oxidant heated to 60 to 80°C for the period of 10 minutes to 30 minutes. Concentration of the permanganate salt in the alkaline permanganate solution is preferably in the range of 5% by mass to 10% by mass. Illustrative examples of the oxidant that is commercially available include alkaline permanganate solutions such as "Concentrate Compact P" and "Dosing Solution Securiganth P", which are manufactured by Atotech Japan K.K.

The neutralizing solution that may be used in the neutralization treatment is preferably an acidic aqueous solution. Illustrative examples of commercially available product of the neutralizing solution include "Reduction Solution Securiganth P", which is manufactured by Atotech Japan K.K. The neutralization treatment with the neutralizing solution may be carried out by soaking the surface, which has been treated with the roughening treatment using the oxidant solution, into the neutralizing solution at 30°C to 80°C for the period of 5 minutes to 30 minutes. From the viewpoint of workability and the like, it is preferable to soak the magnetic layer, which has been treated with the roughening process using the oxidant solution, into the neutralizing solution at 40°C to 70°C for the period of 5 minutes to 20 minutes.

From the viewpoint of enhancing the adhesion with the conductive layer, the arithmetic average roughness (Ra) of the surface of the magnetic layer after the roughening treatment is preferably 300 nm or more, more preferably 350 nm or more, and still more preferably 400 nm or more. The upper limit thereof is preferably 1500 nm or less, more preferably 1200 nm or less, and still more preferably 1000 nm or less. The surface roughness (Ra) may be measured, for example, by using a non-contact type surface roughness meter.

### Step (5)

Fig. 8 is a schematic sectional view to explain the step (5) in the producing method of the circuit board 100 according to the first embodiment of the present invention. The step (5) includes forming a conductive layer 50 on the polished surfaces 40U and 40D of the magnetic layer 40, as illustrated in Fig. 8. In this embodiment, the example is illustrated in which the conductive layer 50 is formed not only on the polished surfaces 40U and 40D of the magnetic layer 40 but also on the surface therearound (for example, the first surface 10U and the second surface 10D of the core substrate 10). In Fig. 8, the example that the conductive layer 50 is formed on both sides of the core substrate 10 is illustrated; but the conductive layer 50 may be formed on one side of the core substrate 10.

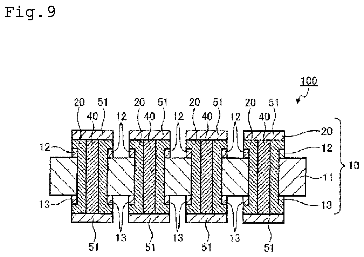

Fig. 9 is a schematic sectional view to explain the step (5) in the production method of the circuit board 100 according to the first embodiment of the present invention. The step (5) may include after the conductive layer 50 is formed, removing parts of the conductive layer 50, the metal layers 12 and 13, and the plated layer 20 by etching or the like to form a patterned conductive layer 51, as illustrated in Fig. 9.

Illustrative examples of the method for forming the conductive layer 50 include a plating method, a sputtering method, and a vapor deposition method. Among these, a plating method is preferable. In a preferable embodiment, the surface of the magnetic layer 40 (and the core substrate 10, as needed) is plated with a suitable method such as a semi-additive method or a full additive method, so that the patterned conductive layer 51 having an intended wiring pattern may be formed. Illustrative examples of the material of the conductive layer 50 include: single metals such as gold, platinum, palladium, silver, copper, aluminum, cobalt, chromium, zinc, nickel, titanium, tungsten, iron, tin, and indium; and alloys of two or more metals selected from the group consisting of gold, platinum, palladium, silver, copper, aluminum, cobalt, chromium, zinc, nickel, titanium, tungsten, iron, tin, and indium. Among these, from the viewpoints of general applicability, cost, easiness in patterning, and the like, preferably usable are chromium, nickel, titanium, aluminum, zinc, gold, palladium, silver, and copper, as well as a nickel-chromium alloy, a copper-nickel alloy, and a copper-titanium alloy. More preferable are chromium, nickel, titanium, aluminum, zinc, gold, palladium, silver, and copper, as well as a nickel-chromium alloy. Copper is still more preferably used.

Here, the example of the method to form the patterned conductive layer 51 will be explained in detail. A plated seed layer is formed on the polished surfaces 40U and 40D of the magnetic layer 40 by electroless plating. Next, after a mask pattern is formed as needed onto the plated seed layer thus formed, an electroplated layer is formed by electroplating. Then, as needed, the mask pattern is removed, and then further an unnecessary plated seed layer is removed by etching or the like, so that the patterned conductive layer 51 having an intended wiring pattern can be formed. After the patterned conductive layer 51 is formed, with an aim to enhance the adhesion strength of the patterned conductive layer 51, an annealing treatment may be carried out, as needed. The annealing treatment may be carried out, for example, by heating at 150°C to 200°C for the period of 20 minutes to 90 minutes.

The thickness of the patterned conductive layer 51 is preferably 1 um or more, more preferably 3 um or more, and still more preferably 5 um or more, and preferably 70 um or less, more preferably 50 um or less, still more preferably 40 um or less, and especially preferably 10 um or less.

By the method described above, the circuit board 100 having the magnetic layer 40 is obtained. The magnetic layer 40 is obtained by curing the resin composition layer 31; thus, this includes the cured product of the resin composition. Therefore, the magnetic layer 40 may contain more magnetic powder (not illustrated in the drawing), so that this can have excellent magnetic properties.

### Second Embodiment

A circuit board according to a second embodiment includes a magnetic layer that is formed by the cured product of the resin composition layer in the resin sheet. The circuit board producing method includes, for example,
(A) a step of laminating a resin sheet to an inner layer substrate such that a resin composition layer is bonded to the inner layer substrate to form a magnetic layer.

The circuit board producing method according to the second embodiment may include an arbitrary step in addition to the step (A). For example, the circuit board producing method may include:
(B) a step of drilling the magnetic layer,
(C) a step of applying a roughening treatment to the magnetic layer, and
(D) a step of forming a conductive layer on the magnetic layer. This producing method preferably includes steps (A) through (D) in this order.

### Step (A)

The step (A) is a step of laminating a resin sheet to an inner layer substrate such that a resin composition layer is bonded to the inner layer substrate to form a magnetic layer. In one embodiment of the step (A), the resin sheet is laminated to the inner layer substrate such that the resin composition layer is bonded to the inner layer substrate, and then, the resin composition layer is thermally cured to form the magnetic layer.

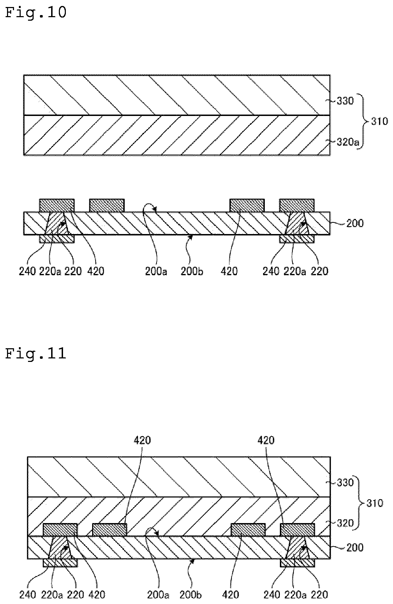

Fig. 10 is a schematic sectional view to explain the step (A) in the circuit board producing method according to the second embodiment of the present invention. At the step (A), a resin sheet 310 having a support 330 and a resin composition layer 320a formed on the support 330 is laminated to an inner layer substrate 200 such that the resin composition layer 320a is bonded to the inner layer substrate 200.

The inner layer substrate 200 is an insulating substrate. Illustrative examples of the material of the inner layer substrate 200 include insulating substrates such as a glass epoxy substrate, a metal substrate, a polyester substrate, a polyimide substrate, a BT resin substrate, and a thermosetting type polyphenylene ether substrate. The inner layer substrate 200 may be an inner layer circuit board having wires or the like incorporated in the thickness thereof.

As illustrated in Fig. 10 as one example, the inner layer substrate 200 has a first conductive layer 420 formed on a first main surface 200a and an outside terminal 240 formed on a second main surface 200b. The first conductive layer 420 may include a plurality of wires. In the example illustrated by the drawing, only a wire that forms a coil-like conductive structural body 400 of an inductor element is illustrated. The outside terminal 240 is a terminal to electrically connect to an outside device or the like that is not illustrated in the drawing. The outside terminal 240 may be formed as part of the conductive layer formed on the second main surface 200b.

Conductive materials that are capable of forming the first conductive layer 420 and the outside terminal 240 are the same as the materials of the conductive layer that have been explained in the section of "Step (5)" in the first embodiment.

The first conductive layer 420 and the outside terminal 240 may be of any of a monolayer structure and a multilayer structure in which two or more layers formed of a single metal layer or an alloy layer formed of different metals are laminated. Thicknesses of the first conductive layer 420 and of the outside terminal 240 are the same as those of a second conductive layer 440 to be described later.

The line (L)/space (S) ratios of the first conductive layer 420 and of the outside terminal 240 are not particularly restricted. From the viewpoint of reducing irregularity of the surface to obtain the magnetic layer that is excellent in the smoothness, the ratio is usually 900/900 um or less, preferably 700/700 um or less, more preferably 500/500 um or less, still more preferably 300/300 um or less, and far still more preferably 200/200 um or less. The lower limit of the line/space ratio is not particularly restricted; from the viewpoint of enhancing an embedding property of the resin composition layer into the space, the ratio is preferably 1/1 um or more.

The inner layer substrate 200 may have a plurality of through holes 220 that are formed so as to penetrate through the inner layer substrate 200 from the first main surface 200a to the second main surface 200b. In a through hole 220, an inside-the-through-hole wiring 220a is formed. The inside-the-through-hole wiring 220a electrically connects the first conductive layer 420 with the outside terminal 240.

Bonding of the resin composition layer 320a to the inner layer substrate 200 is the same as in the method of laminating the core substrate and the resin sheet described in the section of "Step (1)" in the first embodiment.

After the resin sheet is laminated to the inner layer substrate, the resin composition layer is thermally cured to form a magnetic layer. As illustrated in Fig. 11 as one example, the resin composition layer 320a that is bonded to the inner layer substrate 200 is thermally cured to form a first magnetic layer 320.

The thermal curing conditions of the resin composition layer 320a are the same as the thermal curing conditions of the resin composition layer described in the section of "Step (2)" in the first embodiment.

The support 330 may be removed between the time after thermal curing at the step (A) and step (B), or after the step (B).

### Step (B)

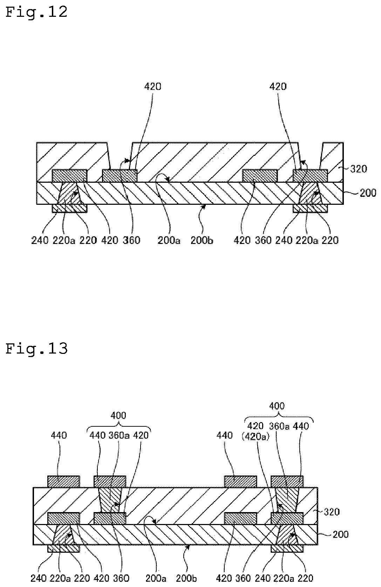

Fig. 12 is a schematic sectional view to explain the step (B) in the circuit board producing method according to the second embodiment of the present invention. At the step (B), a via hole 360 is formed by carrying out the hole-making process in the first magnetic layer 320.

The via hole 360 will be a channel to electrically connect the first conductive layer 420 with the second conductive layer 440 to be described later. Formation of the via hole 360 may be carried out by using a drill, laser, plasma, or the like in accordance with a composition and the like of the resin composition used to form the magnetic layer. The size and shape of the via hole may be determined as appropriate in accordance with a design of the circuit board.

### Step (C)

Step (C) includes roughning the magnetic layer having formed the via hole. The roughening method at the step (C) is the same as in the method that has been explained in the section of "Step (4)" in the first embodiment.

The roughening treatment at the step (C) may also be a polishing treatment of the surface of the insulating layer. The polishing method is the same as in the method that has been explained in the section of "Step (3) " in the first embodiment.

From the viewpoint of enhancing the plating adhesion, the arithmetic average roughness (Ra) of the magnetic layer after the roughening treatment is preferably 300 nm or more, more preferably 350 nm or more, and still more preferably 400 nm or more. The upper limit thereof is preferably 1000 nm or less, more preferably 900 nm or less, and still more preferably 800 nm or less. The surface roughness (Ra) may be measured, for example, by using a non-contact type surface roughness meter.

### Step (D)

Fig. 13 is a schematic sectional view to explain step (D) in the circuit board producing method according to the second embodiment of the present invention. The step (D), as illustrated in Fig. 13 as one example, includes forming the second conductive layer 440 on the first magnetic layer 320.

The conductive materials that are capable of forming the second conductive layer 440 are the same as those of the conductive layer explained in the section of "Step (5)" in the first embodiment.

From the viewpoint of thinning, the thickness of the second conductive layer 440 is preferably 70 um or less, more preferably 60 um or less, still more preferably 50 um or less, far still more preferably 40 um or less, and especially preferably 30 um or less, 20 um or less, 15 um or less, or 10 um or less. The lower limit thereof is preferably 1 um or more, more preferably 3 um or more, and still more preferably 5 um or more.

The second conductive layer 440 may be formed by plating. For example, the second conductive layer 440 is preferably formed by a wet plating method such as a semi-additive method including an electroless plating process, a mask patterning process, an electroplating process, and a flash etching process, as well as by a full additive method. When the second conductive layer 440 is formed by the wet plating method, the second conductive layer 440 having an intended wiring pattern may be formed. Note that, at this step, an inside-the-via-hole wiring 360a is concurrently formed in the via hole 360.

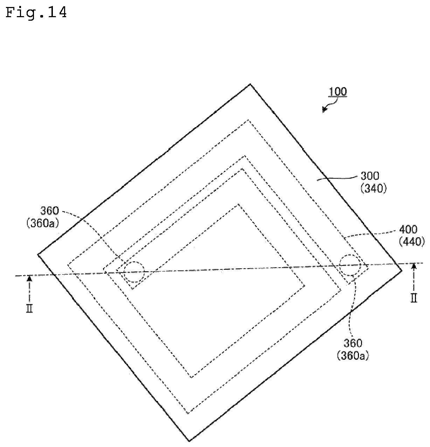

The first conductive layer 420 and the second conductive layer 440 may be formed, for example, spirally, as illustrated in Fig. 14 to Fig. 16 to be described later as one example. In one example, one end on the center side of the spiral wiring part of the second conductive layer 440 is electrically connected through the inside-the-via-hole wiring 360a to one end on the center side of the spiral wiring part of the first conductive layer 420. Another end on the outer circumferential side of the spiral wiring part of the second conductive layer 440 is electrically connected through the inside-the-via-hole wiring 360a to a land 420a of the first conductive layer 42. Therefore, the other end on the outer circumferential side of the spiral wiring part of the second conductive layer 440 is electrically connected to the outside terminal 240 through the inside-the-via-hole wiring 360a, the land 420a, and the inside-the-through-hole wiring 220a.

The coil-like conductive structural body 400 is composed of the spiral wiring part that is a part of the first conductive layer 420, the spiral wiring part that is a part of the second conductive layer 440, and the inside-the-via-hole wiring 360a that electrically connects between the spiral wiring part of the first conductive layer 420 and the spiral wiring part of the second conductive layer 440.

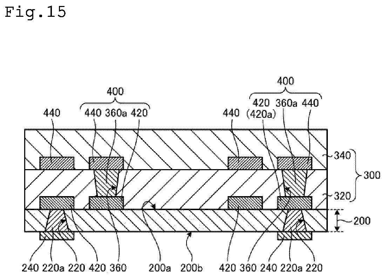

After the step (D), a step of further forming a magnetic layer on the conductive layer may be carried out. Specifically, as illustrated in Fig. 15 as one example, a second magnetic layer 340 is formed on the first magnetic layer 320 that has the second conductive layer 440 and the inside-the-via-hole wiring 360a formed therein. The second magnetic layer may be formed with the same step as the step that has already been explained.

### Inductor Board

The inductor board includes the circuit board of the present invention. When the inductor component includes the circuit board obtained by the circuit board producing method according to the first embodiment, this has an inductor pattern that is formed by a conductor at least in part around the cured product of the resin composition layer. As such an inductor board, the one described in, for example, Japanese Patent Application Laid-open No. 2016-197624 is applicable.

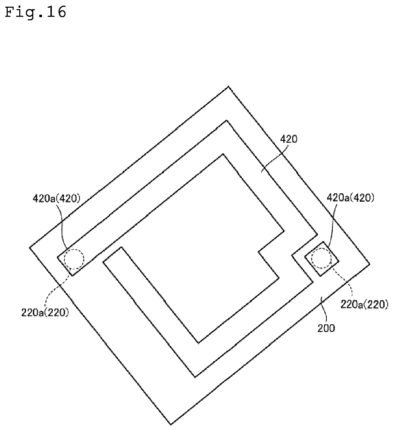

When the inductor board includes the circuit board obtained by the circuit board producing method according to the second embodiment, the inductor board has a magnetic layer and a conductive structural body having at least part thereof been embedded into the magnetic layer. The inductor board includes this conductive structural body and an inductor element that is extendedly present in a thickness direction of the magnetic layer and is composed of part of the magnetic layer surrounded by the conductive structural body. Note that, Fig. 14 is a schematic plan view observed from one side along the thickness direction of the inductor board, which includes the inductor element therein. Fig. 15 is a schematic plan view illustrating a cut end face of the inductor board that is cut at the place indicated by the II-II one dot chain line illustrated in Fig. 14. Fig. 16 is a schematic plan view to explain a composition of the first conductive layer in the inductor board.

As illustrated in Fig. 14 and Fig. 15 as one example, a circuit board 100 has a plurality of magnetic layers (the first magnetic layer 320 and the second magnetic layer 340) and a plurality of conductive layers (the first conductive layer 420 and the second conductive layer 440). Namely, this is a build-up wiring board having a build-up magnetic layer and a build-up conductive layer. Also, the circuit board 100 has an inner layer substrate 200.

From Fig. 15, the first magnetic layer 320 and the second magnetic layer 340 constitute a magnetic portion 300, which may be regarded as an integrated magnetic layer of these magnetic layers. Therefore, the coil-like conductive structural body 400 is formed in such a way that at least part thereof may be embedded into the magnetic member 300. Namely, in the inductor board 100 according to this embodiment, the inductor element is composed of the coil-like conductive structural body 400 and a core part, which is extendedly present in the thickness direction of the magnetic portion 300 and is part of the magnetic member 300 that is surrounded by the coil-like conductive structural body 400.

As illustrated in Fig. 16 as one example, the first conductive layer 420 includes the spiral wiring part to constitute the coil-like conductive structural body 400 and the land 420a in a square shape that is electrically connected to the inside-the-through-hole wiring 220a. In the example illustrated by the drawing, the spiral wiring part includes a linear part, a bent part that is bent at right angle to the linear part, and a detour part that detours the land 420a. In the example illustrated by the drawing, the entire outline of the spiral wiring part of the first conductive layer 420 is almost in a square shape and the wiring part has a shape that is wound in the counterclockwise direction from a center side to an outer side.

Similarly, the second conductive layer 440 is formed on the first magnetic layer 320. The second conductive layer 440 includes the spiral wiring part to constitute the coil-like conductive structural body 400. In Fig. 14 or Fig. 15, the spiral wiring part includes a linear portion and a bent portion that is bent at right angle to the linear portion. In Fig. 14 or Fig. 15, the entire of the outline of spiral wiring part of the second conductive layer 440 is almost in a square shape and the wiring part has a shape that is wound in the clockwise direction from a center side to an outer side.

The inductor board can be used as the wiring board to mount an electronic part such as a semiconductor chip, and may also be used as a (multi-layered) printed wiring board that uses this wiring board as the inner layer substrate. In addition, this may be used as a chip inductor board obtained by dicing the wiring board, and may also be used as a printed wiring board that is surface-mounted with the chip inductor board.

In addition, by using the wiring board like this, semiconductor devices in various forms may be produced. The semiconductor device having the wiring board like this may be suitably used in electric products (for example, a computer, a mobile phone, a digital camera, and a television), vehicles (for example, a motor bike, an automobile, a train, a marine ship, and an airplane), and so forth.

### Examples

Hereinafter, the present invention will be specifically described by examples, but the present invention is not limited to these examples. Note that "part" and "%" with regard to the quantity means "part by mass" and "% by mass", respectively, unless otherwise specifically mentioned.

### First Example

An oligomer resin having a weight-average molecular weight of 600 or more and less than 8000 ("jER1001": manufactured by Mitsubishi Chemical Corp., bisphenol A type epoxy resin, epoxy equivalent weight (EPW) of 475 g/eq., softening temperature of 64°C, bifunctional (2B), weight-average molecular weight of 900) (0.29 parts), 0.91 parts of an epoxy resin ("ZX-1059": manufactured by Nippon Steel Chemical & Material Co., Ltd., a mixture of bisphenol A type epoxy resin and bisphenol F type epoxy resin), 1.17 parts of a phenol resin ("LA-7054": manufactured by DIC Corp., 60%-solid content MEK solution with hydroxyl group equivalent of approximately 125 g/eq.), 40.50 parts of magnetic powder ("ATFINE-NC1·PF10FA": manufactured by Epson Atmix Corp., average particle diameter (D₅₀) of 6.0 µm), 16.20 parts of magnetic powder ("CVD iron powder (0.7 µm)": manufactured by JFE MINERAL & Alloy Co., LTD.), 5.10 parts of magnetic powder ("M001": manufactured by Powdertech Co., Ltd., average particle diameter (D₅₀) of 0.12 um), 0.25 parts of dispersant ("SC-1015F" manufactured by NOF Corp., polyoxyalkylene dispersant), and 3.48 parts of solvent ("Butylcarbitol Acetate": manufactured by Tokyo Chemical Industry Co., Ltd.) were mixed and uniformly dispersed using a high-speed rotary mixer to prepare a resin composition.

### Second Example

In the first example, 0.29 parts of the oligomer resin having a weight-average molecular weight of 600 or more and less than 8000 ("jER1001": manufactured by Mitsubishi Chemical Corp.) was replaced by 0.29 parts of an oligomer resin having a weight-average molecular weight of 600 or more and less than 8000 ("jER1004AF": manufactured by Mitsubishi Chemical Corp., polyether type epoxy resin made from a bisphenol, weight-average molecular weight of 1650). A resin composition was produced in the same way as in the first example except for the above item.

### Third Example

In the first example, 0.29 parts of the oligomer resin having a weight-average molecular weight of 600 or more and less than 8000 ("jER1001": manufactured by Mitsubishi Chemical Corp.) was replaced by 0.29 parts of an oligomer resin having a weight-average molecular weight of 600 or more and less than 8000 ("jER1010": manufactured by Mitsubishi Chemical Corp., bisphenol A type epoxy resin, weight-average molecular weight of 5500). A resin composition was produced in the same way as in the first example except for the above item.

### Fourth Example

In the first example, 0.29 parts of the oligomer resin having a weight-average molecular weight of 600 or more and less than 8000 ("jER1001": manufactured by Mitsubishi Chemical Corp.) was replaced by 0.29 parts of an oligomer resin having a weight-average molecular weight of 600 or more and less than 8000 ("jER4005P": manufactured by Mitsubishi Chemical Corp., bisphenol F type epoxy resin, weight-average molecular weight of 6200). A resin composition was produced in the same way as in the first example except for the above item.

### Fifth Example

In the first example, 0.29 parts of the oligomer resin having a weight-average molecular weight of 600 or more and less than 8000 ("jER1001": manufactured by Mitsubishi Chemical Corp.) was changed to 0.13 parts, and 0.52 parts of a resin having a weight-average molecular weight of 8000 or more ("YX7553H30": manufactured by Mitsubishi Chemical Corp., phenoxy resin with special skeleton, 30% solution in MEK:cyclohexanone=1:1, weight-average molecular weight of 35000) was added. A resin composition was produced in the same way as in the first example except for the above items.

### First Comparative Example

0.91 parts of an epoxy resin ("ZX-1059": manufactured by Nippon Steel Chemical & Material Co., Ltd.,), 1.17 parts of a phenol resin ("LA-7054": manufactured by DIC Corp.), 35.00 parts of magnetic powder ("ATFINE-NC1·PF10FA": manufactured by Epson Atmix Corp.), 14.08 parts of magnetic powder ("CVD iron powder (0.7 µm)": manufactured by JFE MINERAL & Alloy Co., LTD.), 4.43 parts of magnetic powder ("M001": manufactured by Powdertech Co., Ltd.), 0.25 parts of a dispersant ("SC-1015F", manufactured by NOF Corp.), and 3.48 parts of a solvent ("Butylcarbitol Acetate": manufactured by Tokyo Chemical Industry Co., Ltd.) were mixed and uniformly dispersed using a high-speed rotary mixer to prepare a resin composition.

### Second Comparative Example

In the first example,
1) 0.29 parts of the oligomer resin having a weight-average molecular weight of 600 or more and less than 8000 ("jER1001": manufactured by Mitsubishi Chemical Corp.) was changed to 0.73 parts of a resin having a weight-average molecular weight of 8000 or more ("YL9101H40": manufactured by Mitsubishi Chemical Corp., weight-average molecular weight of 9050), and
2) the amount of the solvent ("Butylcarbitol Acetate": manufactured by Tokyo Chemical Industry Co., Ltd.) was changed from 3.48 parts to 3.04 parts.

A resin composition was produced in the same way as in the first example except for the above items.

### Third Comparative Example

In the first example,
1) 0.29 parts of the oligomer resin having a weight-average molecular weight of 600 or more and less than 8000 ("jER1001": manufactured by Mitsubishi Chemical Corp.) was changed to 0.96 parts of a resin having a weight-average molecular weight of 8000 or more ("YX7553H30": manufactured by Mitsubishi Chemical Corp.), and
2) the amount of the solvent ("Butylcarbitol Acetate": manufactured by Tokyo Chemical Industry Co., Ltd.) was changed from 3.48 parts to 2.81 parts.

A resin composition was produced in the same way as in the first example except for the above items.

### Preparation of Resin Sheet A

A polyethylene terephthalate (PET) film ("PET 501010"; thickness of 50 um; manufactured by Lintec Corp.) that was treated with a silicone type releasing treatment was prepared as the support. Each resin composition was uniformly applied onto the releasing surface of the PET film by using a doctor blade such that the thickness of the resin composition layer after drying would become 100 um to obtain a resin sheet A.

### Evaluation of Melt Viscosity

After the support of the resin sheet was peeled off, the resin composition layer was compressed in a mold to produce a pellet for measurement (18-mm diameter, 1.2 g to 1.3 g). This pellet for measurement was then measured for minimum melt viscosity using a dynamic viscoelasticity measuring instrument ("Rheosol-G3000", manufactured by UBM). Specifically, the dynamic viscoelastic modulus was measured for 1 g of the pellet for measurement by increasing the temperature in the range from the starting temperature of 60°C to 200°C using the 18-mm diameter parallel plate, and the minimum melt viscosity (poise) was calculated. The measurement conditions were as follows: temperature raising rate of 5°C/min, temperature measurement interval of 2.5°C, vibration frequency of 1 Hz, and strain of 1 deg.

### Evaluation of Peelability

Whether the resin composition layer could be peeled off from the PET film of the resin sheet A by hand or not was confirmed, and the peelability was evaluated according to the following evaluation criteria.
O: Whole of the resin composition layer could be peeled off from the PET film.
X: Whole of the resin composition layer could not be peeled off from the PET film.

### Measurement of Specific Magnetic Permeability and of Loss Factor

The resin sheet A was heated at 190°C for 90 minutes to thermally cure the resin composition layer; then, the support was peeled off to obtain a cured product in a sheet form. The sheet-like cured product thus obtained was cut to obtain an evaluation sample having an outer diameter of 19.2 mm and an inner diameter of 8.2 mm in the form of donut. The specific magnetic permeability (µ'), the imaginary component of complex magnetic permeability (µ"), and the loss factor (tanδ) of the evaluation sample were measured using a magnetic material test fixture "16454A" manufactured by Keysight Technologies, Inc. and an impedance analyzer "E4991B" manufactured by Keysight Technologies, Inc. at a measurement frequency of 10 MHz and room temperature of 23°C. The loss factor was calculated from the formula [tanδ = µ"/µ'].
O: The specific magnetic permeability is 29 or more.
X: The specific magnetic permeability is less than 29.

**[Table 1]**

| (Table 1) | | | | | | | | | |
|---|---|---|---|---|---|---|---|---|---|
| | | Example | | | | | Comparative Example | | |
| | | 1 | 2 | 3 | 4 | 5 | 1 | 2 | 3 |
| Component (A) | jER1001 | 0.29 | | | | 0.13 | | | |
| | jER1004AF | | 0.29 | | | | | | |
| | jER1010 | | | 0.29 | | | | | |
| | jER4005P | | | | 0.29 | | | | |
| Component (B) | ZX-1059 | 0.91 | 0.91 | 0.91 | 0.91 | 0.91 | 0.91 | 0.91 | 0.91 |
| Component (C) | ATFINE-NC1 PF10FA | 40.50 | 40.50 | 40.50 | 40.50 | 40.50 | 35.00 | 40.50 | 40.50 |
| | CVD iron powder (0.7 *µ*m) | 18.20 | 18.20 | 18.20 | 18.20 | 18.20 | 14.08 | 18.20 | 18.20 |
| | M001 | 5.10 | 5.10 | 5.10 | 5.10 | 5.10 | 4.43 | 5.10 | 5.10 |
| Component (D) | YL9101H40 | | | | | | | 0.725 | |
| | YX7553BH30 | | | | | 0.52 | | | 0.98 |
| Componenet (E) | Butylcarbitol acetate | 3.48 | 3.48 | 3.48 | 3.48 | 3.48 | 3.48 | 304 | 2.81 |
| | MEK | 0.487 | 0.487 | 0.487 | 0.487 | 0.487 | 0.487 | 0.487 | 0.487 |
| Component (F) | LA-7054 | 1.17 | 1.17 | 1.17 | 1.17 | 1.17 | 1.17 | 1.17 | 1.17 |
| Component (G) | SC-1015F | 0.25 | 0.25 | 0.25 | 0.25 | 0.25 | 0.25 | 0.25 | 0.25 |
| Content of component (C) (% by volume) | | 83.2 | 83.2 | 83.2 | 83.2 | 83.2 | 83.2 | 83.2 | 83.2 |
| Dm/(Am+Dm) | | 0 | 0 | 0 | 0 | 0.55 | | 1 | 1 |
| (Am+Dm)/(Am+Bm+Dm) | | 0.24 | 0.24 | 0.24 | 0.24 | 0.24 | 0 | 0.24 | 0.24 |
| Specific magnetic permeability | Measured value | 300 | 30.4 | 29.9 | 29.2 | 29.1 | 29.9 | 28.8 | 28.8 |
| | Evaluation | ○ | ○ | ○ | ○ | ○ | ○ | × | × |
| Loss factor | | 0.020 | 0.028 | 0.023 | 0.024 | 0.019 | 0.019 | 0.023 | 0.022 |
| Peelability | | ○ | ○ | ○ | ○ | ○ | × | ○ | ○ |
| Melt viscosity (poise) | | 5×10⁴ | 1×10⁴ | 1.1×10⁵ | 9.9×10⁴ | 3.9×10³ | 7.4×10³ | 7.7×10³ | 2.8×10⁴ |

| | | | | | | | | | |
|---|---|---|---|---|---|---|---|---|---|
| * In the table, the content (% by volume) of the component (C) represents the content relative to 100% by volume of the non-volatile components in the resin composition. | | | | | | | | | |

## Claims

1. A resin composition comprising:
(A) a resin oligomer having a weight-average molecular weight of 600 or more and less than 8000;
(B) an epoxy resin excluding those falling under the component (A); and
(C) a magnetic powder.

2. The resin composition according to claim 1, wherein the component (A) comprises an epoxy group-containing oligomer.

3. The resin composition according to claim 1 or 2, wherein the resin composition further comprises (D) a polymer compound having a weight-average molecular weight of 8000 or more.

4. The resin composition according to any one of claims 1 to 3, wherein a content (% by volume) of the component (C) relative to 100% by volume of non-volatile components in the resin composition is 70% by volume or more.

5. The resin composition according to claim 3 or 4, wherein Dm/(Am + Dm) is 0 or more and 0.7 or less, provided that Am represents a content of the component (A) and Dm represents a content of the component (D), relative to 100% by mass of non-volatile components in the resin composition.

6. The resin composition according to any one of claims 3 to 5, wherein (Am + Dm)/(Am + Bm + Dm) is 0.1 or more and 0.8 or less, provided that Am represents a content of the component (A), Bm represents a content of the component (B), and Dm represents a content of the component (D), relative to 100% by mass of non-volatile components in the resin composition.

7. The resin composition according to any one of claims 1 to 6, further comprising (E) a solvent.

8. A resin sheet comprising:
a support; and
a resin composition layer that is formed on the support and formed by using the resin composition according to any one of claims 1 to 7.

9. A circuit board comprising:
a substrate having a through hole; and
a cured product of the resin composition according to any one of claims 1 to 7 filled in the through hole.

10. A circuit board comprising a magnetic layer that is a cured product of the resin composition according to any one of claims 1 to 7.

11. An inductor board comprising the circuit board according to claim 9.

12. An inductor board comprising the circuit board according to claim 10.
